# EUROPEAN PATENT SPECIFICATION

(11) **EP 4 064 379 B1**
(45) Date of publication and mention of the grant of the patent: **31.07.2024**
(21) Application number: 21164584.1
(22) Date of filing: 24.03.2021
(51) Int. Cl.: C07F 1/00, H10K 85/30, H10K 50/17

(54) **ORGANIC ELECTRONIC DEVICE, DISPLAY DEVICE COMPRISING THE ORGANIC ELECTRONIC DEVICE AS WELL AS COMPOUNDS FOR USE IN ORGANIC ELECTRONIC DEVICES**
ORGANISCHE ELEKTRONISCHE VORRICHTUNG, ANZEIGEVORRICHTUNG MIT DER ORGANISCHEN ELEKTRONISCHEN VORRICHTUNG SOWIE VERBINDUNGEN ZUR VERWENDUNG IN ORGANISCHEN ELEKTRONISCHEN VORRICHTUNGEN
DISPOSITIF ÉLECTRONIQUE ORGANIQUE, DISPOSITIF D'AFFICHAGE COMPRENANT LE DISPOSITIF ÉLECTRONIQUE ORGANIQUE AINSI QUE DES COMPOSÉS DESTINÉS À ÊTRE UTILISÉS DANS DES DISPOSITIFS ÉLECTRONIQUES ORGANIQUES

(43) Date of publication of application: 28.09.2022
(73) Proprietor: Novaled GmbH, 01099 Dresden (DE)
(72) Inventor: SCHULZE, Benjamin, 01099 Dresden (DE); UVAROV, Vladimir, 01099 Dresden (DE)
(74) Representative: Bittner, Thomas L.

(56) References cited:
- EP-A1- 2 562 839
- US-A1- 2014 116 509

## Description

### TECHNICAL FIELD

The present invention relates to an organic electronic device comprising a compound and a display device comprising the organic electronic device. The invention further relates to novel compounds which can be of use in organic electronic devices.

### BACKGROUND ART

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the semiconductor layer, and among them, may be affected by characteristics of metal complexes which are also contained in the semiconductor layer.

WO2017/029370 A1 (family member EP3133663 A1) relates to an organic electroluminescence device having a hole injection layer comprising a metal complex containing a deprotonated N-sulphonimide is disclosed.

WO 2017/029366 A1 discloses a thick hole injection layer comprising a matrix compound and a metal complex containing a deprotonated N-sulfonimide.

JP 2002-246179 A discloses an organic electroluminescence element which is provided at least with a positive electrode, a light-emitting layer containing an organic luminous substance, and a negative electrode. The organic electroluminescence element contains a metal complex.

There remains a need to improve performance of organic semiconductor materials, semiconductor layers, as well as organic electronic devices thereof, in particular to achieve improved operating voltage, improved lifetime, current efficiency and/or improved operating voltage stability over time through improving the characteristics of the compounds comprised therein.

Additionally, there is a need to provide compounds with improved thermal properties.

### DISCLOSURE

### Organic electronic device

An aspect of the present invention provides an organic electronic device comprising an anode, a cathode, at least one photoactive layer, and at least one semiconductor layer; wherein the at least one semiconductor layer is arranged between the anode and at least one photoactive layer, wherein the at least one semiconductor layer comprises a compound comprising a metal M and at least one ligand L represented by formula (1) 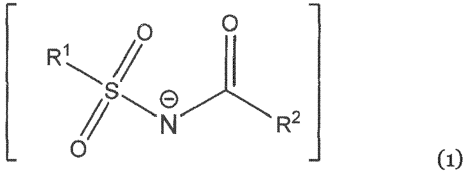 wherein
- R¹ is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R₂ is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R¹ and R² can be connected via a direct bond; and
- R¹ and/or R² taken together with the neighboring sulfur, nitrogen or carbon atom can form a ring, and the ring may be a substituted or unsubstituted ring or a substituted or unsubstituted polycyclic ring or substituted or unsubstituted condensed rings.

It should be noted that throughout the application and the claims any Rⁿ, Mⁿ, etc. always refer to the same moieties, unless otherwise noted.

In the present specification, the term "ligand" refers to an anionic molecule which binds to a cationic metal either by a dative bond or ionic interaction, preferably a dative bond, wherein the nature of the dative bond can have a character ranging from a covalent bond to an ionic bond.

In the present specification, when a definition is not otherwise provided, "partially fluorinated" refers to an alkyl group, an aryl group, a heteroaryl group etc. in which only part of the hydrogen atoms are replaced by fluorine atoms.

In the present specification, when a definition is not otherwise provided, "perfluorinated" refers to an alkyl group, an aryl group, a heteroaryl group etc. in which all hydrogen atoms are replaced by fluorine atoms.

Unless otherwise noted the term "metal" as used herein includes metal cations if the metal is referred to together with an anion, wherein the positive charge of the metal cation and the negative charge of the anion balance each other.

In the present specification, an electron withdrawing group (EWG) is a group that reduces electron density in a molecule through the carbon atom it is bonded to. Typical examples of electron withdrawing groups are halogen, in particular F and Cl, -COR, -COH, -COOR, -COOH, partially fluorinated or perfluorinated alkyl, partially fluorinated or perfluorinated aryl, partially fluorinated or perfluorinated heteroaryl, partially fluorinated or perfluorinated carbocyclyl, partially fluorinated or perfluorinated C₂ to C₂₀ heterocyclyl, -NO₂, and -CN.

In the present specification, when a definition is not otherwise provided, "substituted" refers to one substituted with a deuterium, C₆ to C₁₂ aryl, C₃ to C₁₁, heteroaryl, and C₁ to C₁₂ alkyl, D, C₁ to C₁₂ alkoxy, C₃ to C₁₂ branched alkyl, C₃ to C₁₂ cyclic alkyl, C₃ to C₁₂ branched alkoxy, C₃ to C₁₂ cyclic alkoxy, partially or perfluorinated C₁ to C₁₂ alkyl, partially or perfluorinated C₁ to C₁₂ alkoxy, partially or perdeuterated C₁ to C₁₂ alkyl, partially or perdeuterated C₁ to C₁₂ alkoxy, halogen, CN or PY(R¹⁰)₂, wherein Y is selected from O, S or Se, preferably O and R¹⁰ is independently selected from C₆ to C₁₂ aryl, C₃ to C₁₂ heteroaryl, C₁ to C₆ alkyl, C₁ to C₆ alkoxy, partially or perfluorinated C₁ to C₆ alkyl, partially or perfluorinated C₁ to C₆ alkoxy, partially or perdeuterated C₁ to C₆ alkyl, partially or perdeuterated C₁ to C₆ alkoxy.

In the present specification, when a definition is not otherwise provided, an "alkyl group" refers to a saturated aliphatic hydrocarbyl group. The alkyl group may be a C₁ to C₁₂ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an iso-propyl group, a butyl group, an iso-butyl group, a tert-butyl group, a pentyl group, a hexyl group.

In the context of the present invention, "ⁱCₙH₍₂ₙ₊₁₎" denotes an iso-alkyl group and "ⁱCₙF₍₂ₙ₊₁₎" denotes a perfluorinated iso-alkyl group.

The term "carbocyclyl" as used herein includes all types of not fully saturated organic ringsystems, for example, cycloalkyl, partially unsaturated cycloalkyl etc. monocycles, bicycles, fused ring systems, bridged ring systems, and spirocyclic ring systems are included.

The term "heterocyclyl" as used herein refers to a heterocarbocyclyl.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluorenyl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common sp²-hybridized carbon atoms.

In the present specification, the single bond refers to a direct bond.

In the context of the present invention, "different" means that the compounds do not have an identical chemical structure.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms anode, anode layer and anode electrode are used synonymously.

The terms cathode, cathode layer and cathode electrode are used synonymously.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

The different embodiments described herein may separately or in combination of two or more embodiments be material for realizing the invention.

### Advantageous Effects

Surprisingly, it was found that the compounds of formulas (1) to (3) and (5) as characterized herein have improved thermal properties and that organic electronic devices containing the same as a semiconductor layer, preferably as hole injection layer or hole transport layer, have improved performance in particular current efficiency, stability and life time.

### Compound

According to one embodiment of the present invention, the compound is represented by Formula (2)

Mⁿ⁺Lₙ (2)

wherein n is an integer from 1 to 4, preferably 1 or 3, preferably 1 or 2; and each L is selected independently, preferably each L is the same.

According to one embodiment of the present invention, the compound is represented by Formula (2)

Mⁿ⁺Lₙ (2)

wherein n is an integer of 1 or 2; and each L is the same.

According to one embodiment of the present invention, the compound is represented by Formula (3) 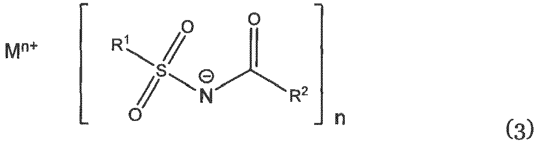 wherein n is an integer from 1 to 4, preferably 1 or 3, preferably 1 or 2.

According to one embodiment of the present invention, the compound is represented by Formula (3) 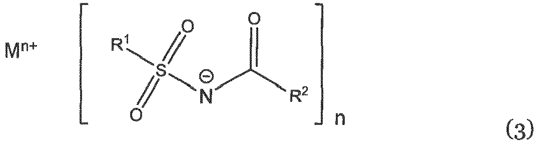 wherein
- M is a metal;
- R¹ is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R₂ is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R¹ and R² can be connected via a direct bond; and
- R¹ and/or R² taken together with the neighboring sulfur, nitrogen or carbon atom can form a ring, and the ring may be a substituted or unsubstituted ring or a substituted or unsubstituted polycyclic ring or substituted or unsubstituted condensed rings.

### Metal

According to one embodiment of the present invention, the metal M is selected from an alkali metal, an alkaline earth metal, a transition metal, or a rare earth metal.

According to one embodiment of the present invention, the metal M is selected from an alkali metal, an alkaline earth metal, or a transition metal.

According to one embodiment of the present invention, the metal M is selected from alkali metals, alkaline earth metals, Pb, Mn, Fe, Co, Ni, Cu, Zn, Ag Cd; rare earth metals in oxidation state (II) or (III); Al, Ga, In; and from Sn, Ti, Zr, Hf, V, Nb, Ta, Cr, Mo and W.

According to one embodiment of the present invention, the metal M is selected from alkaline earth metals, Pb, Mn, Fe, Co, Ni, Cu, Zn, Ag Cd; rare earth metals in oxidation state (II) or (III); Al, Ga, In; and from Sn, Ti, Zr, Hf, V, Nb, Ta, Cr, Mo and W.

According to one embodiment of the present invention, the metal M is selected from an alkali metal, an alkaline earth metal, Cu, Ag, Fe, Co, Ti, Zr, Hf, Mo, or W.

According to one embodiment of the present invention, the metal M is selected from Na, Cu, or Ag.

### R¹ and R²

According to one embodiment of the present invention, R¹ is independently selected from a substituted or unsubstituted C₁ to C₂₀ alkyl, a substituted or unsubstituted C₆ to C₂₀ aryl, or a substituted or unsubstituted C₂ to C₂₀ heteroaryl.

According to one embodiment of the present invention, R² is independently selected from a substituted or unsubstituted C₁ to C₂₀ alkyl, a substituted or unsubstituted C₆ to C₂₀ aryl, or a substituted or unsubstituted C₂ to C₂₀ heteroaryl.

According to one embodiment of the present invention, R² is independently selected from a substituted C₁ to C₂₀ alkyl, a substituted C₆ to C₂₀ aryl, or a substituted C₂ to C₂₀ heteroaryl.

According to one embodiment of the present invention, R² is independently selected from a substituted C₁ to C₂₀ alkyl.

According to one embodiment of the present invention, R¹ is independently selected from a substituted or unsubstituted C₁ to C₂₀ alkyl, a substituted or unsubstituted C₆ to C₂₀ aryl or a substituted or unsubstituted C₂ to C₂₀ heteroaryl;
R² is independently selected from a substituted or unsubstituted C₁ to C₂₀ alkyl, a substituted or unsubstituted C₆ to C₂₀ aryl or a substituted or unsubstituted C₂ to C₂₀ heteroaryl;
R¹ and R² can be connected via a direct bond; and
R¹ and R² taken together with the neighboring sulfur, nitrogen or carbon atom can form a ring, and the ring may be a substituted or substituted C₆ to C₂₀ ring or C₆ to C₂₀ polycyclic ring, or a substituted or unsubstituted condensed C₆ to C₂₀ rings.

According to one embodiment of the present invention, R¹ is independently selected from a substituted or unsubstituted C₁ to C₂₀ alkyl, a substituted or unsubstituted C₆ to C₂₀ aryl or a substituted or unsubstituted C₂ to C₂₀ heteroaryl;
R² is independently selected from a substituted or unsubstituted C₁ to C₂₀ alkyl, a substituted or unsubstituted C₆ to C₂₀ aryl or a substituted or unsubstituted C₂ to C₂₀ heteroaryl; and
R¹ and R² can be connected via a direct bond.

According to one embodiment of the present invention, R¹ is independently selected from a substituted or unsubstituted C₁ to C₂₀ alkyl, a substituted or unsubstituted C₆ to C₂₀ aryl or a substituted or unsubstituted C₂ to C₂₀ heteroaryl; and
R² is independently selected from a substituted or unsubstituted C₁ to C₂₀ alkyl, a substituted or unsubstituted C₆ to C₂₀ aryl or a substituted or unsubstituted C₂ to C₂₀ heteroaryl.

According to one embodiment of the present invention, R¹ is independently selected from a substituted or unsubstituted C₁ to C₂₀ alkyl, a substituted or unsubstituted C₆ to C₂₀ aryl or a substituted or unsubstituted C₂ to C₂₀ heteroaryl;
R² is independently selected from a substituted C₁ to C₂₀ alkyl preferably perfluorinated C₁ to C₁₂ alkyl, perfluorinated C₁ to C₁₀ alkyl, perfluorinated C₁ to C₈ alkyl, perfluorinated C₁ to C₆ alkyl, perfluorinated C₁ to C₄ alkyl, a substituted or unsubstituted C₆ to C₂₀ aryl or a substituted or unsubstituted C₂ to C₂₀ heteroaryl;
R¹ and R² can be connected via a direct bond; and
R¹ and R² taken together with the neighboring sulfur, nitrogen or carbon atom can form a ring, and the ring may be a substituted or substituted C₆ to C₂₀ ring or C₆ to C₂₀ polycyclic ring, or a substituted or unsubstituted condensed C₆ to C₂₀ rings.

According to one embodiment of the present invention, R¹ is independently selected from a substituted or unsubstituted C₁ to C₂₀ alkyl, a substituted or unsubstituted C₆ to C₂₀ aryl or a substituted or unsubstituted C₂ to C₂₀ heteroaryl; and
R² is independently selected from a substituted C₁ to C₂₀ alkyl preferably perfluorinated C₁ to C₁₂ alkyl, perfluorinated C₁ to C₁₀ alkyl, perfluorinated C₁ to C₈ alkyl, perfluorinated C₁ to C₆ alkyl, perfluorinated C₁ to C₄ alkyl, a substituted or unsubstituted C₆ to C₂₀ aryl or a substituted or unsubstituted C₂ to C₂₀ heteroaryl; and
R¹ and R² can be connected via a direct bond.

According to one embodiment of the present invention, R¹ is independently selected from a substituted or unsubstituted C₁ to C₂₀ alkyl, a substituted or unsubstituted C₆ to C₂₀ aryl or a substituted or unsubstituted C₂ to C₂₀ heteroaryl; and
R₂ is independently selected from a substituted C₁ to C₂₀ alkyl preferably perfluorinated C₁ to C₁₂ alkyl, perfluorinated C₁ to C₁₀ alkyl, perfluorinated C₁ to C₈ alkyl, perfluorinated C₁ to C₆ alkyl, perfluorinated C₁ to C₄ alkyl, a substituted or unsubstituted C₆ to C₂₀ aryl or a substituted or unsubstituted C₂ to C₂₀ heteroaryl.

According to one embodiment of the present invention, for each R¹ and R² aryl is independently phenyl, naphthyl, anthracene, or 9-phenanthryl.

According to one embodiment of the present invention, for each R¹ and R² aryl is independently phenyl or naphthyl.

According to one embodiment of the present invention, for each R¹ and R² aryl is independently phenyl.

According to one embodiment of the present invention, for each R¹ and R² heteroaryl is independently pyridinyl, pyrimidinyl, pyriazinyl or pirazinyl.

According to one embodiment of the present invention, for each R¹ and R² heteroaryl is independently pyridinyl.

According to one embodiment of the present invention, for each R¹ and R² heteroaryl is independently F or CF₃-substituted pyridinyl, pyrimidinyl, pyriazinyl, pirazinyl

According to one embodiment of the present invention, R² substituted heteroaryl is independently For CF₃-substituted pyridinyl, pyrimidinyl, pyriazinyl, pirazinyl.

According to one embodiment of the present invention, for each R¹ and R² alkyl is independently branched or unbranched alkyl or cycloalkyl.

According to one embodiment of the present invention, for each R¹ and R² alkyl is independently branched or unbranched alkyl.

According to one embodiment of the present invention, for each R¹ and R² alkyl is independently C₁ to C₂₀ alkyl, C₁ to C₁₈ alkyl, C₁ to C₁₆ alkyl, C₁ to C₁₄ alkyl, C₁ to C₁₂, C₁ to C₁₀, C₁ to C₈ alkyl, C₁ to C₆ alkyl, or C₁ to C₄ alkyl.

According to one embodiment of the present invention, R¹ and R² are independently selected from
- CH₃, - CH₂CH₃, - CH₂CH₂CH₃, - CH(CH₃)₂, - CH₂CH₂CH₂CH₃, - CH(CH₃)(CH₂CH₃), - C(CH₃)₃, - CH₂CH₂CH₂CH₂CH₃, - CH₂CH₂CH₂CH₂CH₂CH₃, -CF₃, -CF₂CF₃, -CF₂CF₂CF₃, -CF(CF₃)₂, -CH₂CF₂CF₃, -CH(CF₃)₂, -CF₂CF₂CF₂CF₃, -C(CF₃)₃, -CF(CF₃)(CF₂CF₃), -CF₂CF₂CF₂CF₂CF₃, -CF₂CF₂CF₂CF₂CF₂CF₃,

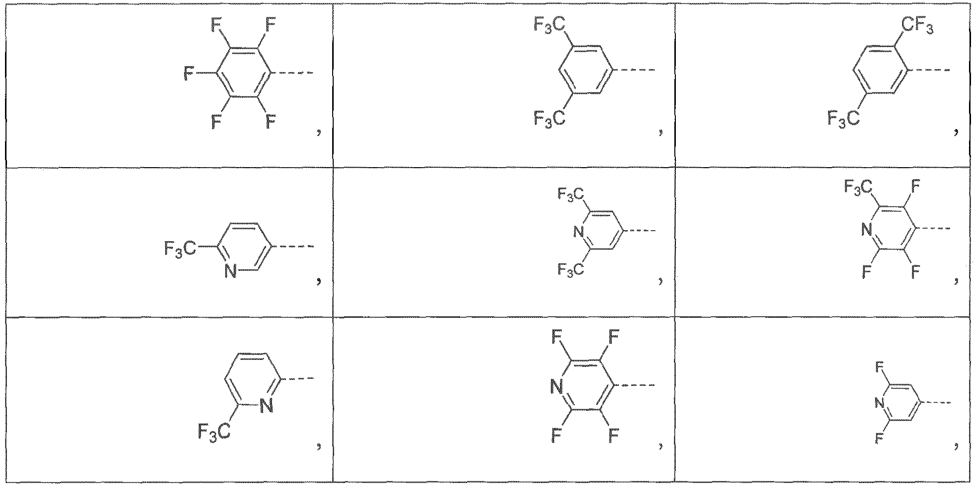

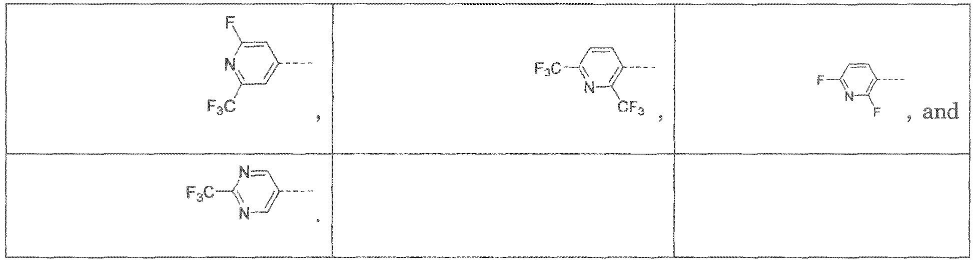

According to one embodiment of the present invention, R¹ and R² are independently selected from
CH₃, - CH₂CH₃, - CH₂CH₂CH₃, - CH(CH₃)₂, - CH₂CH₂CH₂CH₃, - CH(CH₃)(CH₂CH₃), - C(CH₃)₃, -CF₃, - CF₂CF₃, - CF₂CF₂CF₃, - CF(CF₃)₂, -CH₂CF₂CF₃, -CH(CF₃)₂, - CF₂CF₂CF₂CF₃, - C(CF₃)₃, - CF(CF₃)(CF₂CF₃), - CF₂CF₂CF₂CF₂CF₃, - CF₂CF₂CF₂CF₂CF₂CF₃,

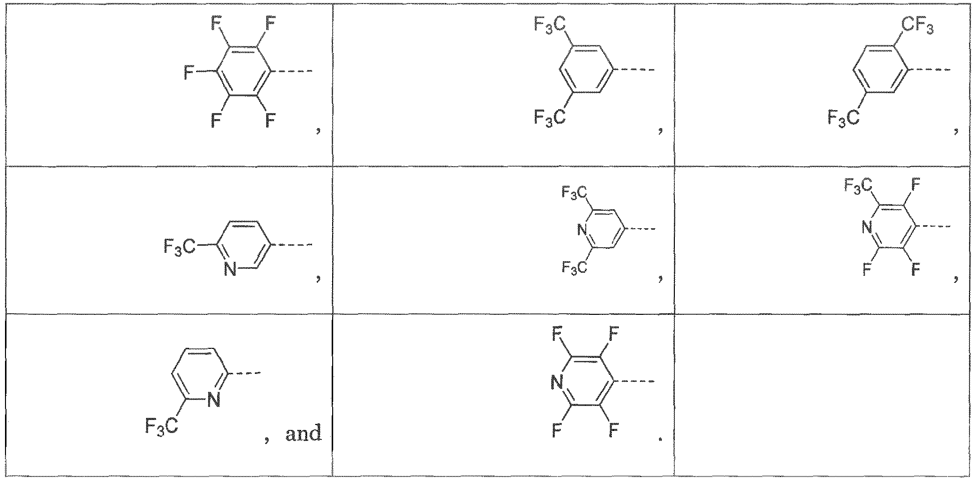

According to one embodiment of the present invention, R¹ is selected from
-CH₃, -CH₂CH₃, - CH₂CH₂CH₃, - CH(CH₃)₂, - CH₂CH₂CH₂CH₃, - CH(CH₃)(CH₂CH₃), - C(CH₃)₃, -CF₃, - CF₂CF₃, - CF₂CF₂CF₃, - CF(CF₃)₂, -CH₂CF₂CF₃, -CH(CF₃)₂, - CF₂CF₂CF₂CF₃, - C(CF₃)₃, - CF(CF₃)(CF₂CF₃), - CF₂CF₂CF₂CF₂CF₃, - CF₂CF₂CF₂CF₂CF₂CF₃,

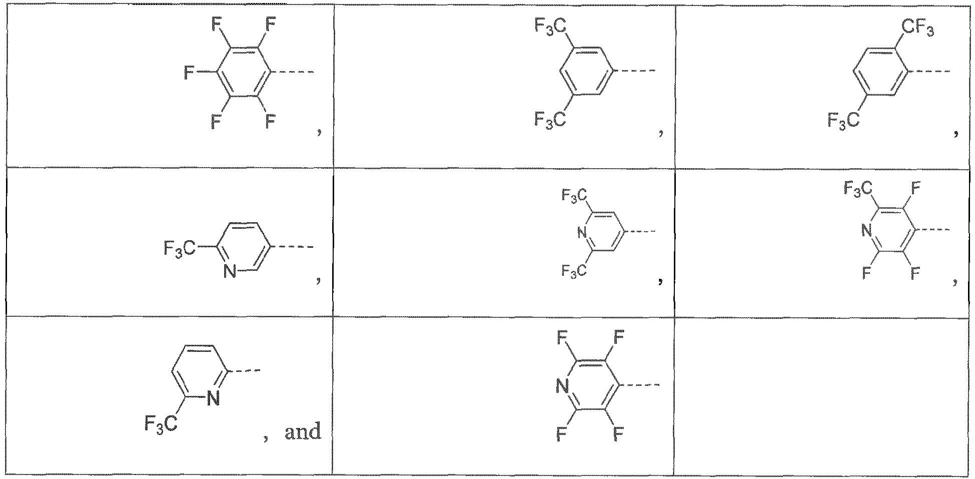

According to one embodiment of the present invention, R₂ is selected from
-CF₃, - CF₂CF₃, - CF₂CF₂CF₃, - CF(CF₃)₂, - CF₂CF₂CF₂CF₃, - C(CF₃)₃, - CF(CF₃)(CF₂CF₃), - CF₂CF₂CF₂CF₂CF₃, - CF₂CF₂CF₂CF₂CF₂CF₃,

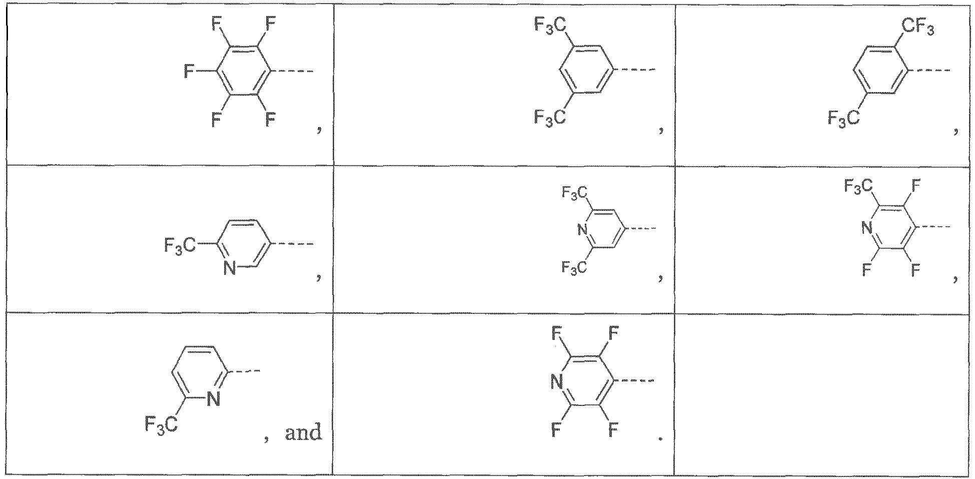

### Substituents

According to one embodiment of the present invention, if at least one of R¹ and R² is substituted then at least one substituent on R1 and/or R2 is an electron-withdrawing group.

According to one embodiment of the present invention, at least one of R¹ and R² is substituted and at least one substituent on R¹ and/or R² is an electron-withdrawing group.

According to one embodiment of the present invention, the electron-withdrawing group is selected from halogen, preferably Cl or F, CN, COR3, COOR³, a partially fluorinated or perfluorinated C₁ to C₁₀ alkyl, partially fluorinated or perfluorinated C₆ to C₂₀ aryl, partially fluorinated or perfluorinated C₂ to C₂₀ heteroaryl, a partially fluorinated or perfluorinated C₃ to C₂₀ carbocyclyl, or a partially fluorinated or perfluorinated C₂ to C₂₀ heterocyclyl; wherein R³ is selected from hydrogen, a substituted or unsubstituted C₁ to C₈ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl. Preferably R³ is selected from hydrogen, a substituted or unsubstituted C₁ to C₈ alkyl, a substituted or unsubstituted C₆ to C₂₀ aryl, or a substituted or unsubstituted C₂ to C₂₀ heteroaryl.

According to one embodiment of the present invention, the electron-withdrawing group is independently selected from halogen, Cl, F, CN, a partially fluorinated or perfluorinated C₁ to C₁₀ alkyl, partially fluorinated or perfluorinated C₆ to C₂₀, aryl, and partially fluorinated or perfluorinated C₂ to C₂₀ heteroaryl.

According to one embodiment of the present invention, the electron-withdrawing group is independently selected from halogen, preferably Cl, F, CN, and a partially fluorinated or perfluorinated C₁ to C₁₀ alkyl.

According to one embodiment of the present invention, at least one of R¹ and R² is substituted and at least one substituent on R¹ and/or R² is an electron-withdrawing group, wherein the electron-withdrawing group is independently selected from halogen, Cl, F, CN, a partially fluorinated or perfluorinated C₁ to C₁₀ alkyl, partially fluorinated or perfluorinated C₆ to C₂₀, aryl, and partially fluorinated or perfluorinated C₂ to C₂₀ heteroaryl.

According to one embodiment of the present invention, at least one of R¹ and R² is substituted and at least one substituent on R¹ and/or R² is an electron-withdrawing group, wherein the electron-withdrawing group is independently selected from halogen, preferably Cl, F, CN, and a partially fluorinated or perfluorinated C₁ to C₁₀ alkyl.

### Ligands

According to one embodiment of the present invention, the ligand L is selected from A-1 to A-129

| | | |
|---|---|---|
| 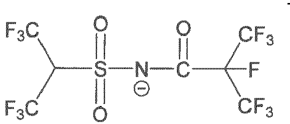 | 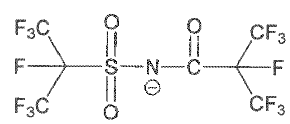 | 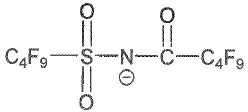 |
| A-1 | A-2 | A-3 |
| 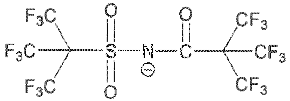 | 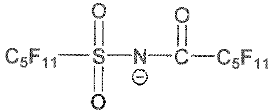 | 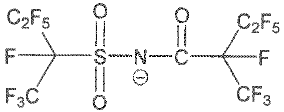 |
| A-4 | A-5 | A-6 |
| 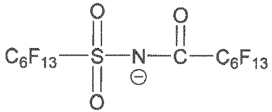 | 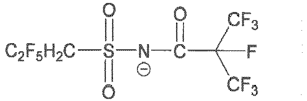 | 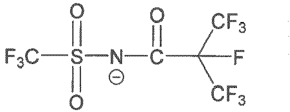 |
| A-7 | A-8 | A-9 |
| 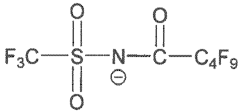 | 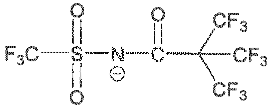 | 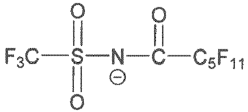 |
| A-10 | A-11 | A-12 |
| 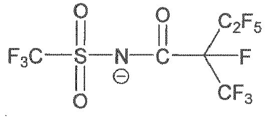 | 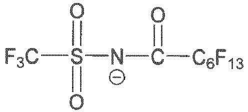 | 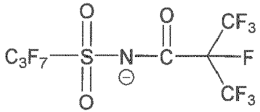 |
| A-13 | A-14 | A-15 |
| 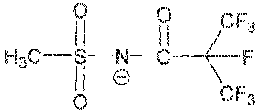 | 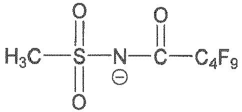 | 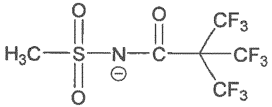 |
| A-16 | A-17 | A-18 |
| 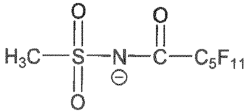 | 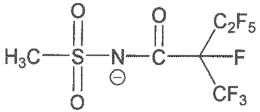 | 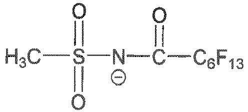 |
| A-19 | A-20 | A-21 |
| 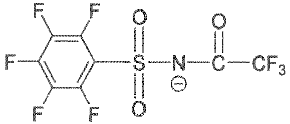 | 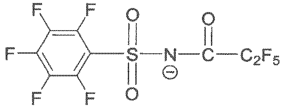 | 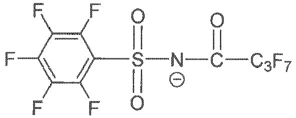 |
| A-22 | A-23 | A-24 |
| 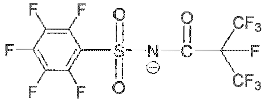 | 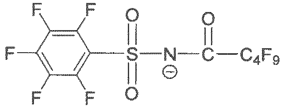 | 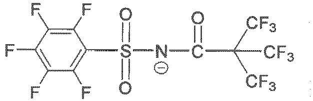 |
| A-25 | A-26 | A-27 |
| 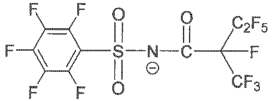 | 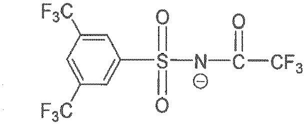 | 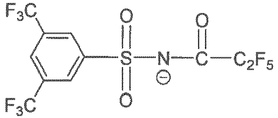 |
| A-28 | A-29 | A-30 |
| 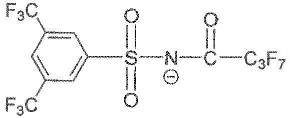 | 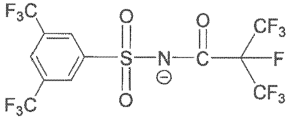 | 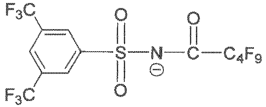 |
| A-31 | A-32 | A-33 |
| 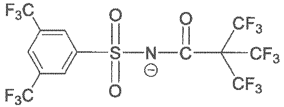 | 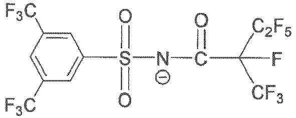 | 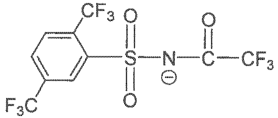 |
| A-34 | A-35 | A-36 |
| 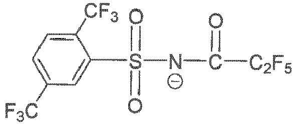 | 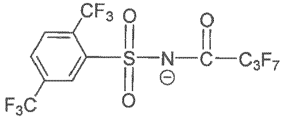 | 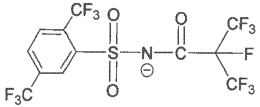 |
| A-37 | A-38 | A-39 |
| 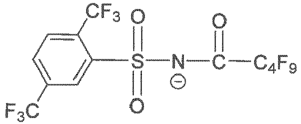 | 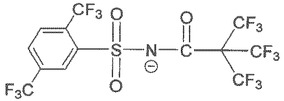 | 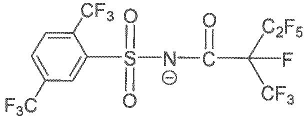 |
| A-40 | A-41 | A-42 |
| 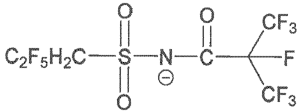 | 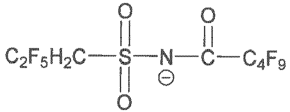 | 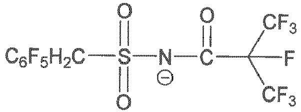 |
| A-46 | A-47 | A-48 |
| 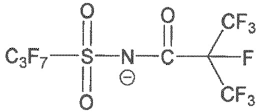 | 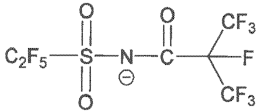 | 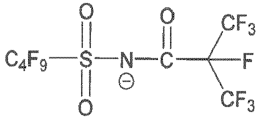 |
| A-49 | A-50 | A-51. |
| 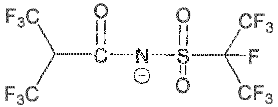 | 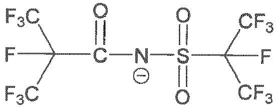 | 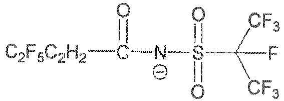 |
| A-52 | A-53 | A-54 |
| 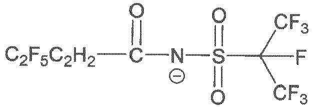 | 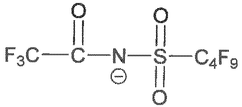 | 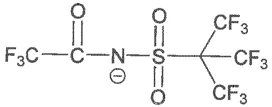 |
| A-55 | A-55 | A-56 |
| 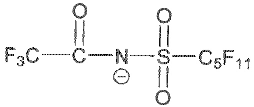 | 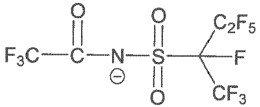 | 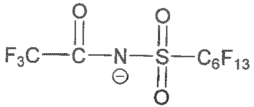 |
| A-57 | A-58 | A-59 |
| 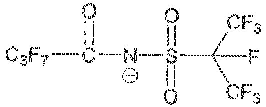 | 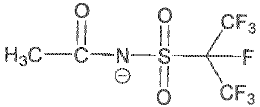 | 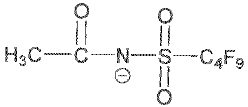 |
| A-60 | A-61 | A-62 |
| 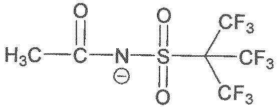 | 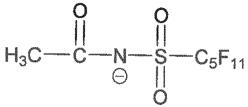 | 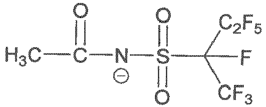 |
| A-63 | A-64 | A-65 |
| 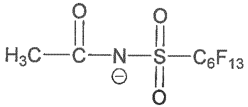 | 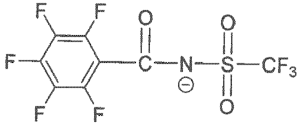 | 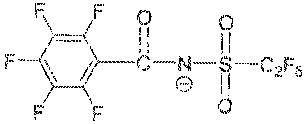 |
| A-66 | A-67 | A-68 |
| 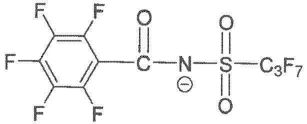 | 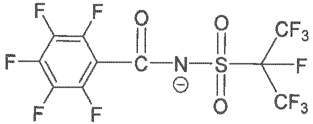 | 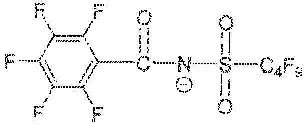 |
| A-69 | A-70 | A-71 |
| 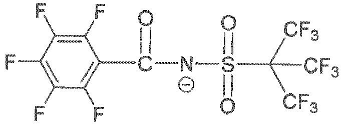 | 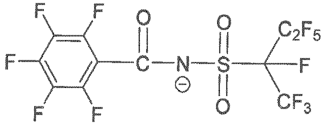 | 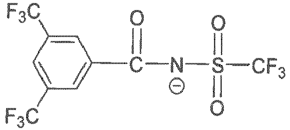 |
| A-72 | A-73 | A-74 |
| 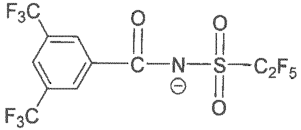 | 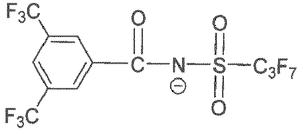 | 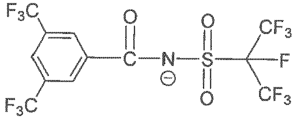 |
| A-75 | A-76 | A-77 |
| 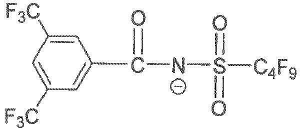 | 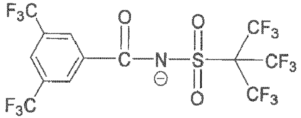 | 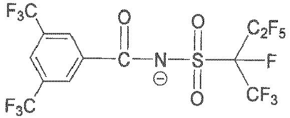 |
| A-78 | A-79 | A-80 |
| 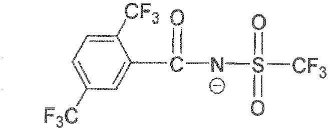 | 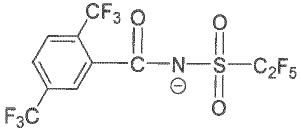 | 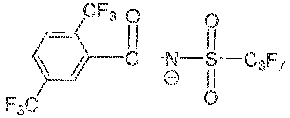 |
| A-81 | A-82 | A-83 |
| 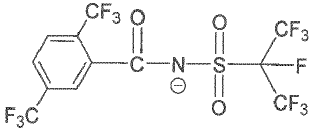 | 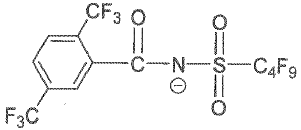 | 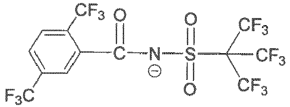 |
| A-84 | A-85 | A-86 |
| 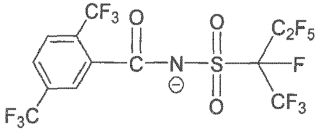 | 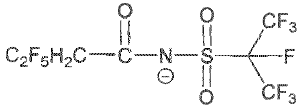 | 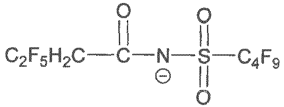 |
| A-87 | A-88 | A-89 |
| 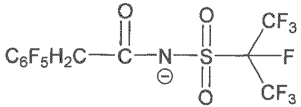 | 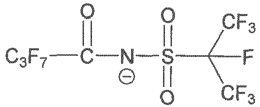 | 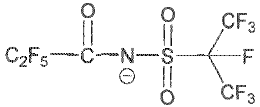 |
| A-90 | A-91 | A-92 |
| 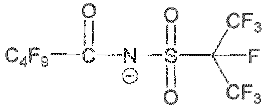 | 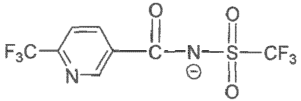 | 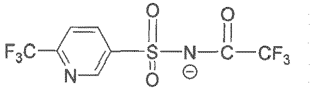 |
| A-93 | A-94 | A-95 |
| 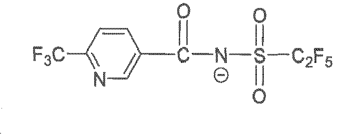 | 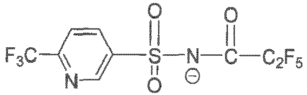 | 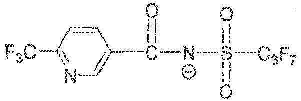 |
| A-96 | A-97 | A-98 |
| 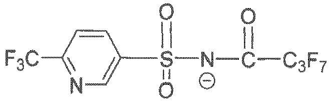 | 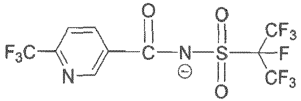 | 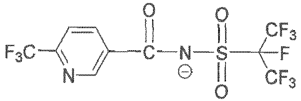 |
| A-99 | A-100 | A-101 |
| 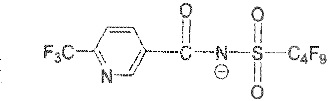 | 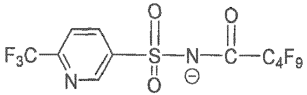 | 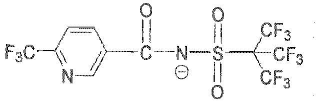 |
| A-102 | A-103 | A-104 |
| 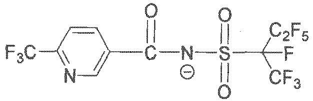 | 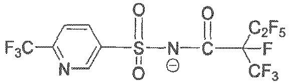 | 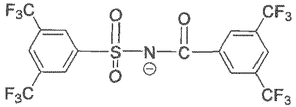 |
| A-105 | A-106 | A-107 |
| 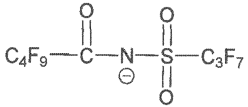 | 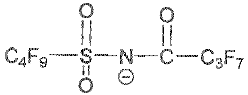 | 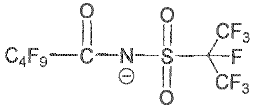 |
| A-108 | A-109 | A-110 |
| 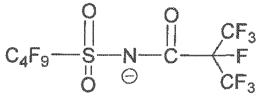 | 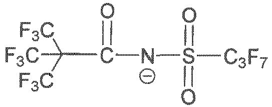 | 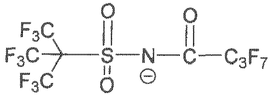 |
| A-111 | A-112 | A-113 |
| 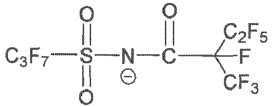 | 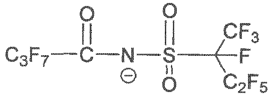 | 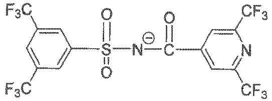 |
| A-114 | A-115 | A-116 |
| 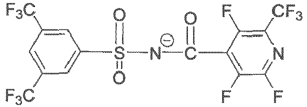 | 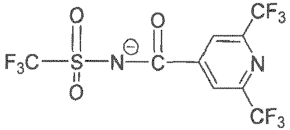 | 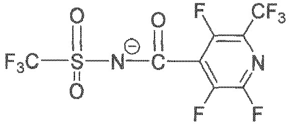 |
| A-117 | A-118 | A-119 |
| 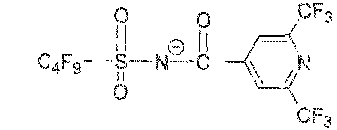 | 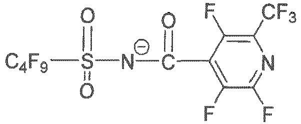 | 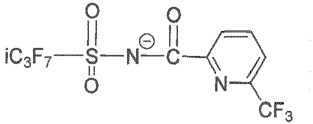 |
| 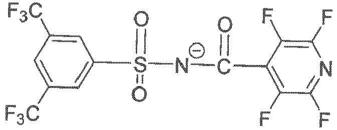 | 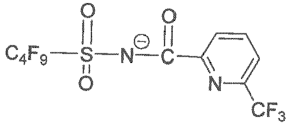 | 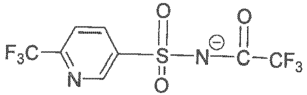 |
| A-120 | A-121 | A-122 |
| 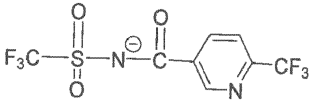 | 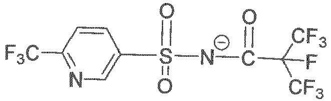 | 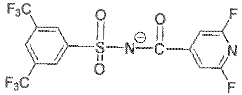 |
| A-123 | A-124 | A-125 |
| 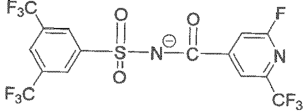 | 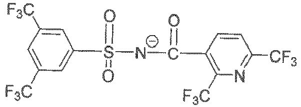 | 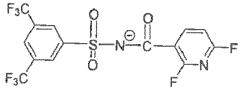 |
| A-126 | A-127 | A-128 |
| 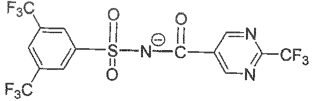 | | |
| A-129 | | |

According to one embodiment of the present invention, the ligand L is selected from

| | | |
|---|---|---|
| 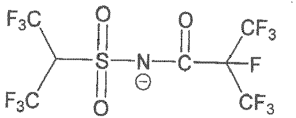 | 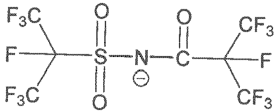 | 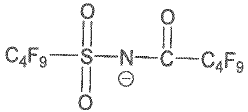 |
| A-1 | A-2 | A-3 |
| 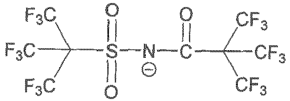 | 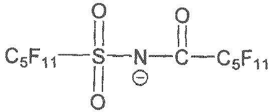 | 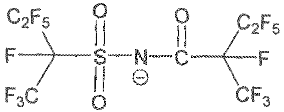 |
| A-4 | A-5 | A-6 |
| 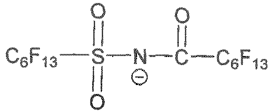 | 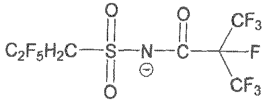 | 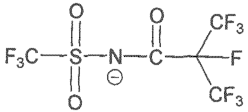 |
| A-7 | A-8 | A-9 |
| 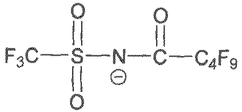 | 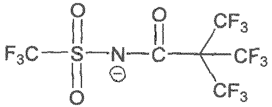 | 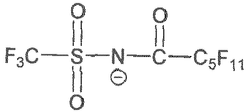 |
| A-10 | A-11 | A-12 |
| 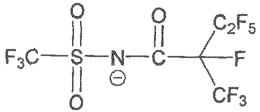 | 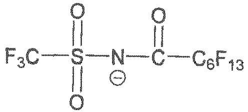 | 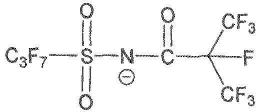 |
| A-13 | A-14 | A-15 |
| 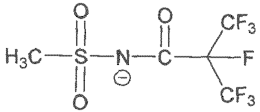 | 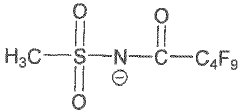 | 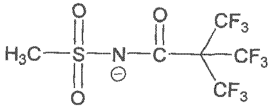 |
| A-16 | A-17 | A-18 |
| 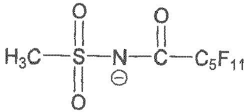 | 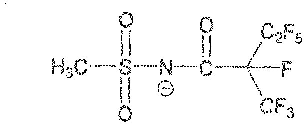 | 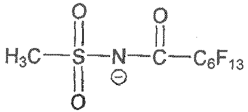 |
| A-19 | A-20 | A-21 |
| 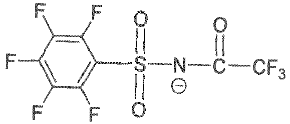 | 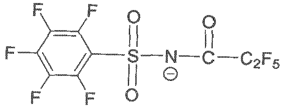 | 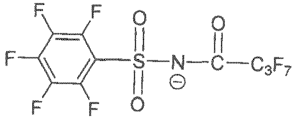 |
| A-22 | A-23 | A-24 |
| 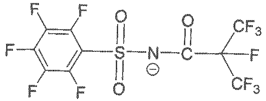 | 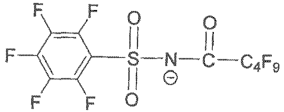 | 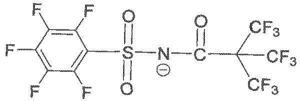 |
| A-25 | A-26 | A-27 |
| 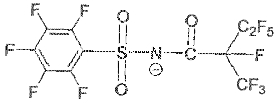 | 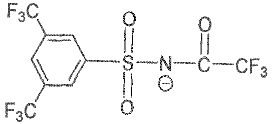 | 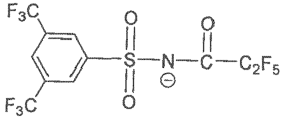 |
| A-28 | A-29 | A-30 |
| 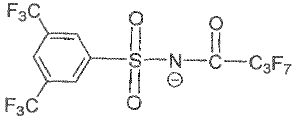 | 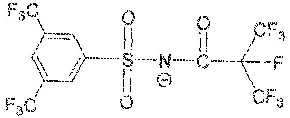 | 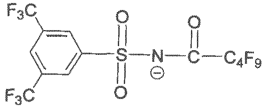 |
| A-31 | A-32 | A-33 |
| 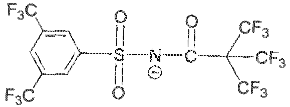 | 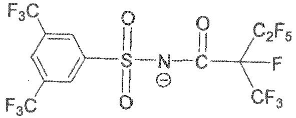 | 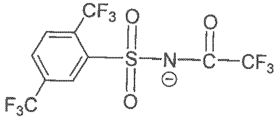 |
| A-34 | A-35 | A-36 |
| 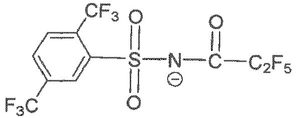 | 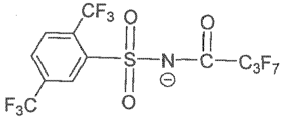 | 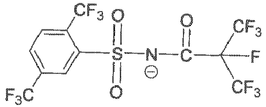 |
| A-37 | A-38 | A-39 |
| 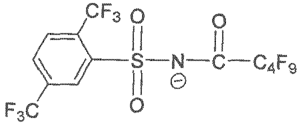 | 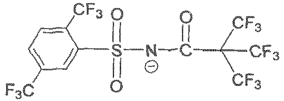 | 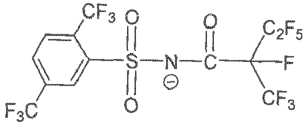 |
| A-40 | A-41 | A-42 |
| 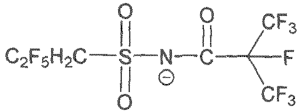 | 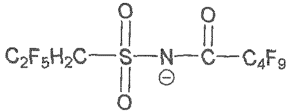 | 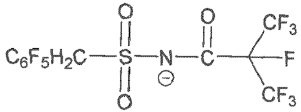 |
| A-46 | A-47 | A-48 |
| 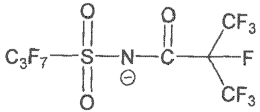 | 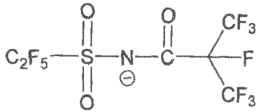 | 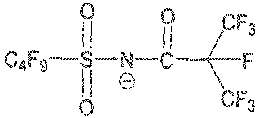 |
| A-49 | A-50 | A-51. |
| 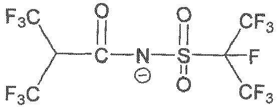 | 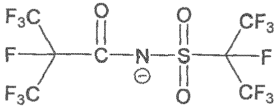 | 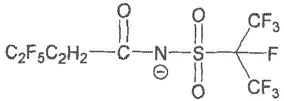 |
| A-52 | A-53 | A-54 |
| 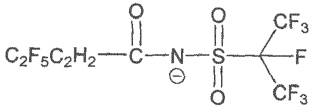 | 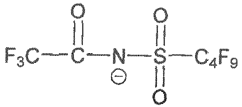 | 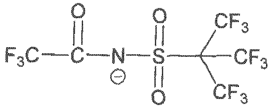 |
| A-55 | A-55 | A-56 |
| 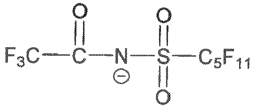 | 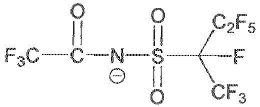 | 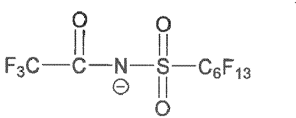 |
| A-57 | A-58 | A-59 |
| 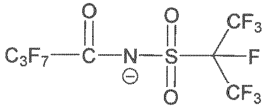 | 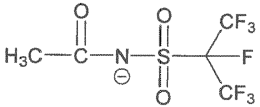 | 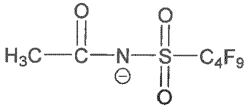 |
| A-60 | A-61 | A-62 |
| 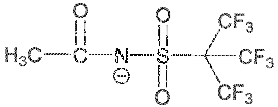 | 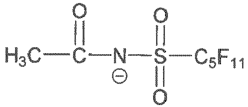 | 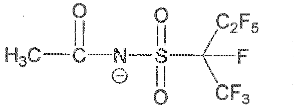 |
| A-63 | A-64 | A-65 |
| 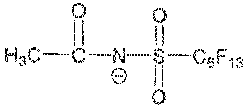 | 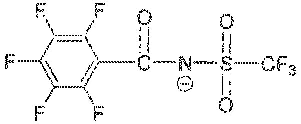 | 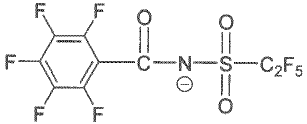 |
| A-66 | A-67 | A-68 |
| 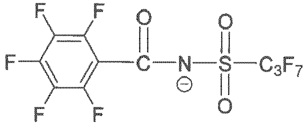 | 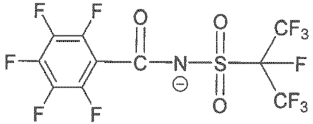 | 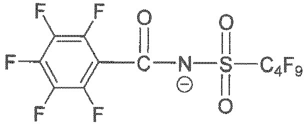 |
| A-69 | A-70 | A-71 |
| 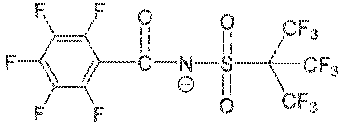 | 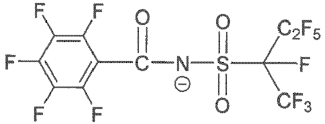 | 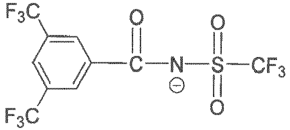 |
| A-72 | A-73 | A-74 |
| 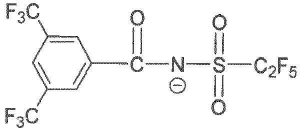 | 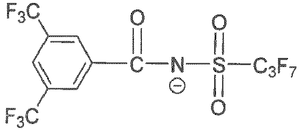 | 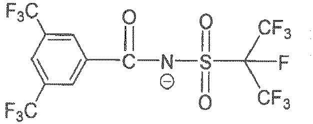 |
| A-75 | A-76 | A-77 |
| 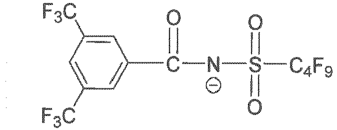 | 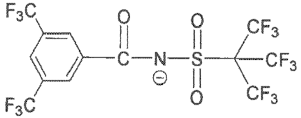 | 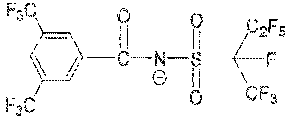 |
| A-78 | A-79 | A-80 |
| 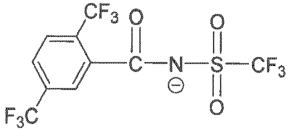 | 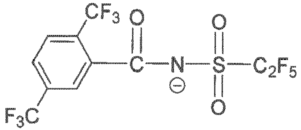 | 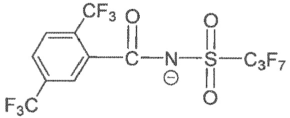 |
| A-81 | A-82 | A-83 |
| 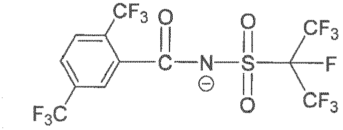 | 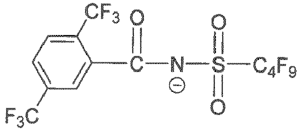 | 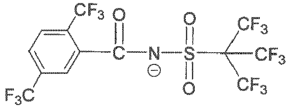 |
| A-84 | A-85 | A-86 |
| 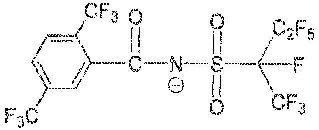 | 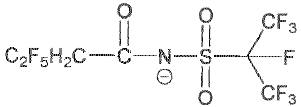 | 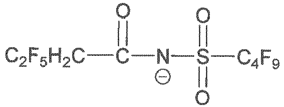 |
| A-87 | A-88 | A-89 |
| 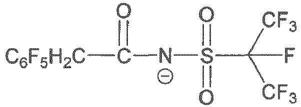 | 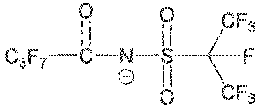 | 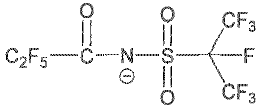 |
| A-90 | A-91 | A-92 |
| 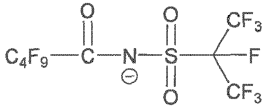 | 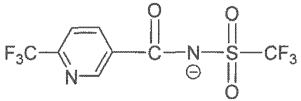 | 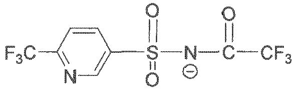 |
| A-93 | A-94 | A-95 |
| 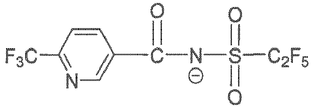 | 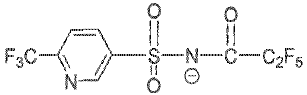 | 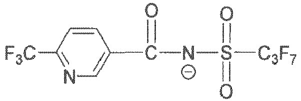 |
| A-96 | A-97 | A-98 |
| 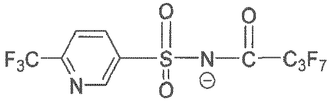 | 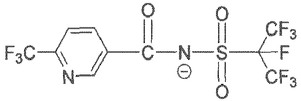 | 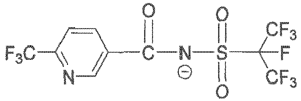 |
| A-99 | A-100 | A-101 |
| 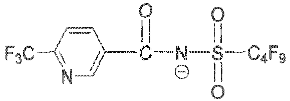 | 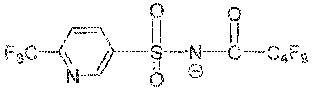 | 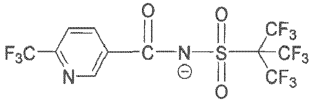 |
| A-102 | A-103 | A-104 |
| 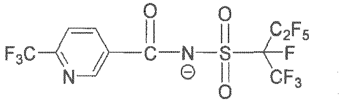 | 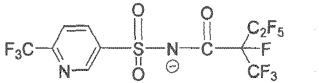 | 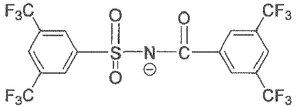 |
| A-105 | A-106 | A-107 |
| 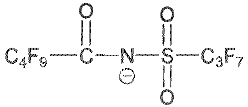 | 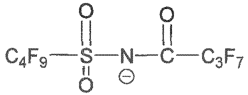 | 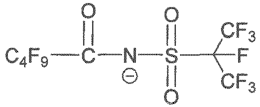 |
| A-108 | A-109 | A-110 |
| 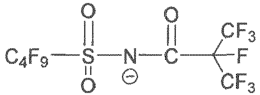 | 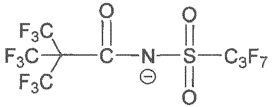 | 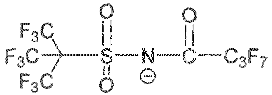 |
| A-111 | A-112 | A-113 |
| 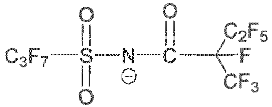 | 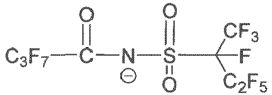 | 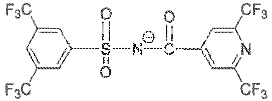 |
| A-114 | A-115 | A-116 |
| 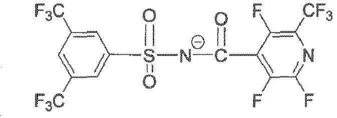 | 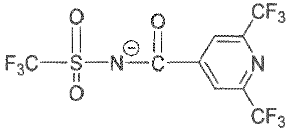 | 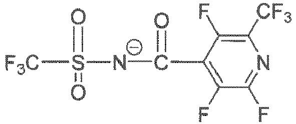 |
| A-117 | A-118 | A-119 |
| 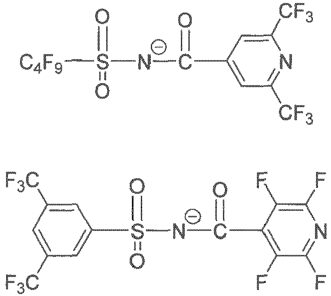 | 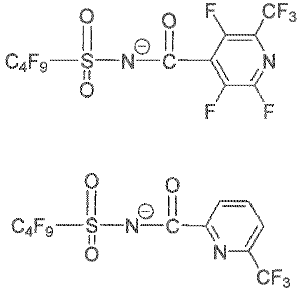 | 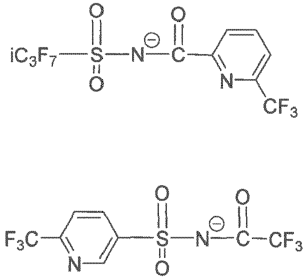 |
| A-120 | A-121 | A-122 |
| 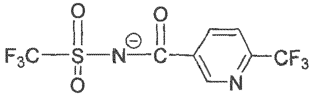 | 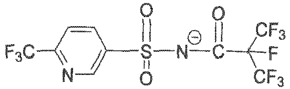 | |
| A-123 | A-124 | |

### Further embodiments

According to one embodiment the present invention provides an organic electronic device comprising an anode, a cathode, at least one photoactive layer, and at least one semiconductor layer; wherein the at least one semiconductor layer is arranged between the anode and at least one photoactive layer, wherein the at least one semiconductor layer comprises a compound comprising a metal M and at least one ligand L represented by formula (1) 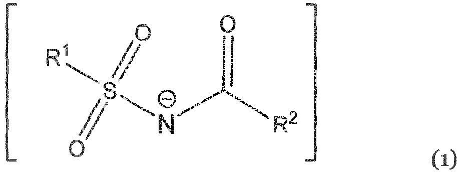 wherein
- R¹ is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R² is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R¹ and R² can be connected via a direct bond;
- R¹ and/or R² taken together with the neighboring sulfur, nitrogen or carbon atom can form a ring, and the ring may be a substituted or unsubstituted ring or a substituted or unsubstituted polycyclic ring or substituted or unsubstituted condensed rings; and
- if at least one of R¹ and R² is substituted then at least one substituent on R¹ and/or R² is an electron-withdrawing group.

According to one embodiment the present invention provides an organic electronic device comprising an anode, a cathode, at least one photoactive layer, and at least one semiconductor layer; wherein the at least one semiconductor layer is arranged between the anode and at least one photoactive layer, wherein the at least one semiconductor layer comprises a compound comprising a metal M and at least one ligand L represented by formula (1) 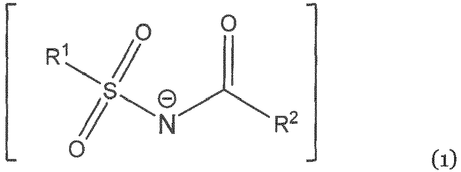 wherein
- R¹ is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R² is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R¹ and R² can be connected via a direct bond;
- R¹ and/or R² taken together with the neighboring sulfur, nitrogen or carbon atom can form a ring, and the ring may be a substituted or unsubstituted ring or a substituted or unsubstituted polycyclic ring or substituted or unsubstituted condensed rings; and
- at least one of R¹ and R² is substituted and at least one substituent on R¹ and/or R² is an electron-withdrawing group.

According to one embodiment the present invention provides an organic electronic device comprising an anode, a cathode, at least one photoactive layer, and at least one semiconductor layer; wherein the at least one semiconductor layer is arranged between the anode and at least one photoactive layer, wherein the at least one semiconductor layer comprises a compound comprising a metal M and at least one ligand L represented by formula (1) 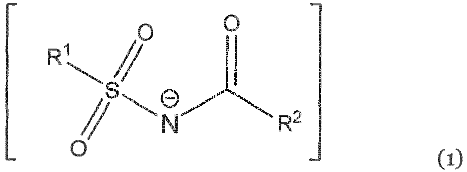 wherein
- R¹ is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R² is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R¹ and R² can be connected via a direct bond;
- R¹ and/or R² taken together with the neighboring sulfur, nitrogen or carbon atom can form a ring, and the ring may be a substituted or unsubstituted ring or a substituted or unsubstituted polycyclic ring or substituted or unsubstituted condensed rings; and
- at least one of R¹ and R² is substituted and at least one substituent on R¹ and/or R² is an electron-withdrawing group, wherein the electron-withdrawing group is independently selected from halogen, preferably Cl, F, CN, and a partially fluorinated or perfluorinated C₁ to C₁₀ alkyl.

According to one embodiment the invention provides an organic electronic device comprising an anode, a cathode, at least one photoactive layer, and at least one semiconductor layer; wherein the at least one semiconductor layer is arranged between the anode and at least one photoactive layer, wherein the at least one of the at least one semiconductor layer comprises a compound represented by formula (3) 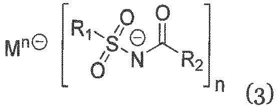
wherein M is a metal,
n is an integer selected from 1 to 4, preferably 1 to 2;
R¹ is independently selected from a substituted or unsubstituted C₁ to C₂₀ alkyl, a substituted or unsubstituted C₆ to C₂₀ aryl or a substituted or unsubstituted C₂ to C₂₀ heteroaryl;
R² is independently selected from a substituted C₁ to C₂₀, a substituted or unsubstituted C₆ to C₂₀ aryl or a substituted or unsubstituted C₂ to C₂₀ heteroaryl;
R¹ and R² can be connected via a direct bond;
R¹ and R² taken together with the neighboring sulfur, nitrogen or carbon atom can form a ring, and the ring may be a substituted or substituted C₆ to C₂₀ ring or C₆ to C₂₀ polycyclic ring, or a substituted or unsubstituted condensed C₆ to C₂₀ rings; and
wherein at least one substituent on R¹ or R² is substituted and the at least one substituent on R¹ or R² is independently selected from halogen, Cl, F, CN, a partially fluorinated or perfluorinated C₁ to C₁₀ alkyl.

According to one embodiment the invention provides an organic electronic device comprising an anode, a cathode, at least one photoactive layer, and at least one semiconductor layer; wherein the at least one semiconductor layer is arranged between the anode and at least one photoactive layer, wherein the at least one semiconductor layer comprises a compound represented by formula (3) 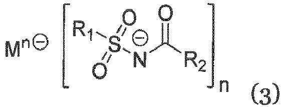
wherein M is a metal,
n is an integer selected from 1 to 4, preferably 1 to 2;
R¹ is independently selected from a substituted or unsubstituted C₁ to C₂₀ alkyl, a substituted or unsubstituted C₆ to C₂₀ aryl or a substituted or unsubstituted C₂ to C₂₀ heteroaryl;
R₂ is independently selected from a substituted C₁ to C₂₀, a substituted or unsubstituted C₆ to C₂₀ aryl or a substituted or unsubstituted C₂ to C₂₀ heteroaryl;
R¹ and R² can be connected via a direct bond; and
if at least one R¹ or R² is substituted then at least one substituent on R¹ or R² is independently selected from Cl, F, CN, a partially fluorinated or perfluorinated C₁ to C₁₀ alkyl.

According to one embodiment the invention provides an organic electronic device comprising an anode, a cathode, at least one photoactive layer, and at least one semiconductor layer; wherein the at least one semiconductor layer is arranged between the anode and at least one photoactive layer, wherein the at least one semiconductor layer comprises a compound represented by formula (3) 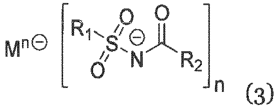
wherein M is an alkali metal, alkaline earth metal, transition metal,
n is an integer selected from 1 to 4, preferably 1 to 2;
R¹ is independently selected from a substituted or unsubstituted C₁ to C₂₀ alkyl, a substituted or unsubstituted C₆ to C₂₀ aryl or a substituted or unsubstituted C₂ to C₂₀ heteroaryl; and
R² is independently selected from a substituted C₁ to C₂₀, a substituted or unsubstituted C₆ to C₂₀ aryl or a substituted or unsubstituted C₂ to C₂₀ heteroaryl;
wherein at least one substituent on R¹ or R² is substituted and the at least one substituent on R¹ or R² is independently selected from halogen, Cl, F, CN, a partially fluorinated or perfluorinated C₁ to C₁₀ alkyl.

According to one embodiment the invention provides an organic electronic device comprising an anode, a cathode, at least one photoactive layer, and at least one semiconductor layer; wherein the at least one semiconductor layer is arranged between the anode and at least one photoactive layer, wherein the at least one semiconductor layer comprises a compound represented by formula (3) 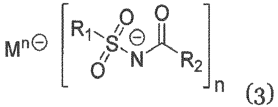
wherein M is Na, Cu, or Ag,
n is an integer of 1 to 2;
R¹ is independently selected from a substituted or unsubstituted C₁ to C₂₀ alkyl, a substituted or unsubstituted C₆ to C₂₀ aryl or a substituted or unsubstituted C₂ to C₂₀ heteroaryl; and
R² is independently selected from a substituted C₁ to C₂₀ alkyl preferably perfluorinated C₁ to C₁₂ alkyl, perfluorinated C₁ to C₁₀ alkyl, perfluorinated C₁ to C₈ alkyl, perfluorinated C₁ to C₆ alkyl, perfluorinated C₁ to C₄ alkyl, a substituted or unsubstituted C₆ to C₂₀ aryl or a substituted or unsubstituted C₂ to C₂₀ heteroaryl;
wherein at least one substituent on R¹ or R² is substituted and the at least one substituent on R¹ or R² is independently selected from Cl, F, CN, or a partially fluorinated or perfluorinated C₁ to C₁₀ alkyl.

### Compounds

According to one embodiment of the present invention, the compound is selected from B-1 to B-8

| | |
|---|---|
| 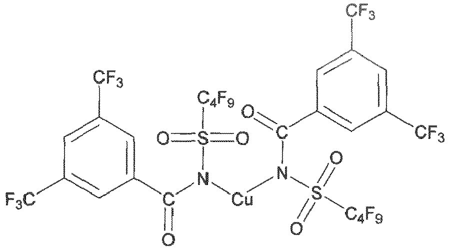 | 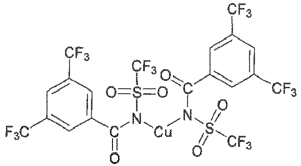 |
| B-1 | B-2 |
| 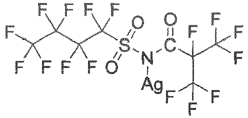 | 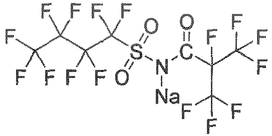 |
| B-3 | B-4 |
| 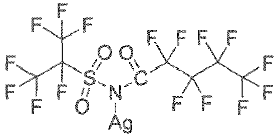 | 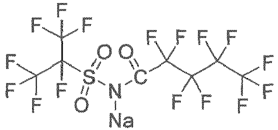 |
| B-5 | B-6 |
| 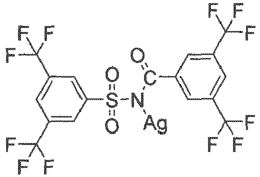 | 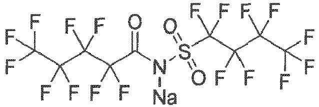 |
| B-7 | B-8 |

### Device

According to one embodiment of the present invention, the organic electronic device is a light emitting device, or a photovoltaic cell, preferably a light emitting device.

According to one embodiment of the present invention, the semiconductor layer and/or the compound of formula (1) to (3) and (5) are non-emissive.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

According to one embodiment of the present invention, the photoactive layer is a light emitting layer.

According to one embodiment of the present invention, the semiconductor layer is a hole injection layer or a hole transport layer.

According to one embodiment of the present invention, the semiconductor layer is a hole injection layer.

According to one embodiment of the present invention, the at least semiconductor layer and the at least one photoactive layer are arranged between the anode and the cathode.

According to one embodiment of the present invention, the organic electronic device comprises at least two or at least three semiconductor layers, wherein the at least two semiconductor layers or the at least three semiconductor layers are arranged between the anode and the at least one photoactive layer.

According to one embodiment of the present invention, the organic electronic device comprises a first and a second semiconductor layer, wherein the first and the second semiconductor layer are arranged between the anode and the at least one photoactive layer, wherein the first semiconductor layer comprises said compounds wherein the first semiconductor layer is closer to the anode than the second semiconductor layer.

According to one embodiment of the present invention, the organic electronic device comprises a first semiconductor layer, a second semiconductor layer and a third semiconductor layer, wherein the first, the second and third semiconductor layer are arranged between the anode and the at least one photoactive layer, wherein the first semiconductor layer comprises said compounds, wherein the first semiconductor layer is closer to the anode than the second and third semiconductor layer.

According to one embodiment of the present invention, the anode layer comprises a first anode sub-layer and a second anode sub-layer.

According to one embodiment of the present invention, the first anode sub-layer comprises a first metal having a work function in the range of ≥ 4 and ≤ 6 eV, and/or the second anode sub-layer comprises a transparent conductive oxide; and/or the second anode sub-layer is arranged closer to the hole injection layer.

According to one embodiment of the present invention, the at least one semiconductor layer comprises a compound of formula (1) to (3) or (5) in an amount in the range of about > 50 wt.-% to about < 100 wt.-%, preferably about > 60 wt.- % to about < 100 wt.-%, further preferred about > 70 wt.-% to about < 100 wt.-%, in addition preferred about > 80 wt.-% to about < 100 wt.-%, or about > 95 wt.-% to about < 100 wt.-%, or about > 98 wt.-% to about < 100 wt.-%, with respect to the total weight of the semiconductor layer, respectively.

According to one embodiment of the present invention, the organic semiconductor layer may comprise:
- at least about ≥ 0.5 wt.-% to about ≤ 30 wt.-%, preferably about ≥ 0.5 wt.-% to about ≤ 20 wt.-%, and more preferred about ≥ 1 wt.-% to about ≤ 15 wt.-% of a compound of formula (1) to (3) or (5), and
- at least about ≥ 70 wt.-% to about ≤ 99.5 wt.-%, preferably about ≥ 80 wt.-% to about ≤ 99.5 wt.-%, and more preferred about ≥ 85 wt.-% to about ≤ 99 wt.-% of a substantially covalent matrix compound; preferably the wt.-% of the compound of formula (1) to (3) or (5) is lower than the wt.-% of the substantially covalent matrix compound; wherein the weight-% of the components are based on the total weight of the organic semiconductor layer.

According to one embodiment of the present invention, the at least one semiconductor layer further comprises a matrix compound.

According to one embodiment of the present invention, the matrix is non-polymeric.

According to one embodiment the organic semiconductor layer may further comprises a substantially covalent matrix compound.

According to one embodiment the substantially covalent matrix compound may be selected from at least one organic compound. The substantially covalent matrix may consist substantially of covalently bound C, H, O, N, S, which optionally comprise in addition covalently bound B, P, As and/or Se.

According to one embodiment of the organic electronic device, the organic semiconductor layer further comprises a substantially covalent matrix compound, wherein the substantially covalent matrix compound may be selected from organic compounds consisting substantially from covalently bound C, H, O, N, S, which optionally comprise in addition covalently bound B, P, As and/or Se.

Organometallic compounds comprising covalent bonds carbon-metal, metal complexes comprising organic ligands and metal salts of organic acids are further examples of organic compounds that may serve as substantially covalent matrix compounds of the hole injection layer.

In one embodiment, the substantially covalent matrix compound lacks metal atoms and majority of its skeletal atoms may be selected from C, O, S, N. Alternatively, the substantially covalent matrix compound lacks metal atoms and majority of its skeletal atoms may be selected from C and N.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and 900 g/mol, also preferred a molecular weight Mw of ≥ 600 and ≤ 800 g/mol.

Preferably, the substantially covalent matrix compound comprises at least one arylamine moiety, alternatively a diarylamine moiety, alternatively a triarylamine moiety.

In one embodiment, the HOMO level of the substantially covalent matrix compound may be more negative than the HOMO level of N2,N2,N2',N2',N7,N7,N7',N7'-octakis(4-methoxyphenyl)-9,9'-spirobi[fluorene]-2,2',7,7'-tetraamine (CAS 207739-72-8) when determined under the same conditions.

In one embodiment, the HOMO level of the substantially covalent matrix compound may be more negative than the HOMO level of N,N'-Bis(naphthalen-1-yl)-N,N'-bis(phenyl)-benzidine (CAS 123847-85-8) when determined under the same conditions.

In one embodiment, the HOMO level of the substantially covalent matrix compound may be more negative than the HOMO level of N-([1,1'-biphenyl]-4-yl)-9,9-dimethyl-N-(4-(9-phenyl-9H-carbazol-3-yl)phenyl)-9H-fluoren-2-amine (CAS 1242056-42-3) when determined under the same conditions.

In one embodiment, the HOMO level of the substantially covalent matrix compound, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the se, may be more negative than -4.27 eV, preferably more negative than -4.3 eV, alternatively more negative than -4.5 eV, alternatively more negative than -4.6 eV, alternatively more negative than - 4.65 eV.

In one embodiment, the HOMO level of the substantially covalent matrix compound may be more negative than the HOMO level of N2,N2,N2',N2',N7,N7,N7',N7'-octakis(4-methoxyphenyl)-9,9'-spirobi[fluorene]-2,2',7,7'-tetraamine (CAS 207739-72-8) and more positive than the HOMO level of N-([1,1'-biphenyl]-4-yl)-N-(2-(9,9-diphenyl-9H-fluoren-4-yl)phenyl)-9,9-dimethyl-9H-fluoren-2-amine when determined under the same conditions.

In one embodiment of the present invention, the substantially covalent matrix compound may be free of alkoxy groups.

In one embodiment, the HOMO level of the substantially covalent matrix compound, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, may be selected in the range of < -4.27 eV and ≥ -4.84 eV, alternatively in the range of < - 4.3 eV and ≥ -4.84 eV, alternatively in the range of < -4.5 eV and ≥ -4.84 eV, alternatively in the range of < -4.5 eV and ≥ -4.84 eV, alternatively in the range of < -4.6 eV and ≥ -4.84 eV.

In the context of the present specification, "more negative" means that the absolute value is more positive than the comparative value.

Preferably, the substantially covalent matrix compound is free of metals and/or ionic bonds.

### Matrix compound

According to another aspect of the present invention, the at least one matrix compound, also referred to as "substantially covalent matrix compound", may comprises at least one arylamine compound, diarylamine compound, triarylamine compound, a compound of formula (VI) or a compound of formula (VII): 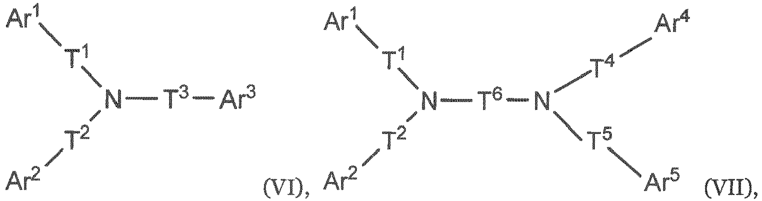 wherein:
T¹, T², T³, T⁴ and T⁵ are independently selected from a single bond, phenylene, biphenylene, terphenylene or naphthenylene, preferably a single bond or phenylene;
T⁶ is phenylene, biphenylene, terphenylene or naphthenylene;
Ar¹, Ar², Ar³, Ar⁴ and Ar⁵ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar¹, Ar², Ar³, Ar⁴ and Ar⁵ are selected the same or different from the group comprising H, D, F, C(-O)R², CN, Si(R²)₃, P(-O)(R²)₂, OR², S(-O)R², S(-O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

According to an embodiment wherein T¹, T², T³, T⁴ and T⁵ may be independently selected from a single bond, phenylene, biphenylene or terphenylene. According to an embodiment wherein T¹, T², T³, T⁴ and T⁵ may be independently selected from phenylene, biphenylene or terphenylene and one of T¹, T², T³, T⁴ and T⁵ are a single bond. According to an embodiment wherein T¹, T², T³, T⁴ and T⁵ may be independently selected from phenylene or biphenylene and one of T¹, T², T³, T⁴ and T⁵ are a single bond. According to an embodiment wherein T¹, T², T³, T⁴ and T⁵ may be independently selected from phenylene or biphenylene and two of T¹, T², T³, T⁴ and T⁵ are a single bond.

According to an embodiment wherein T¹, T² and T³ may be independently selected from phenylene and one of T¹, T² and T³ are a single bond. According to an embodiment wherein T¹, T² and T³ may be independently selected from phenylene and two of T¹, T² and T³ are a single bond.

According to an embodiment wherein T⁶ may be phenylene, biphenylene, terphenylene. According to an embodiment wherein T⁶ may be phenylene. According to an embodiment wherein T⁶ may be biphenylene. According to an embodiment wherein T⁶ may be terphenylene.

According to an embodiment wherein Ar¹, Ar², Ar³, Ar⁴ and Ar⁵ may be independently selected from D1 to D16: 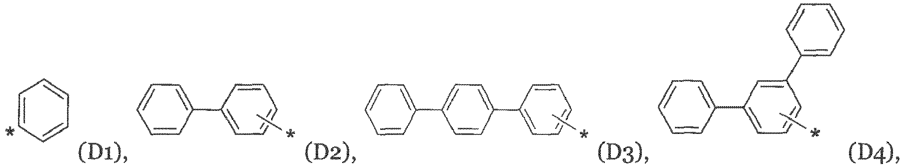 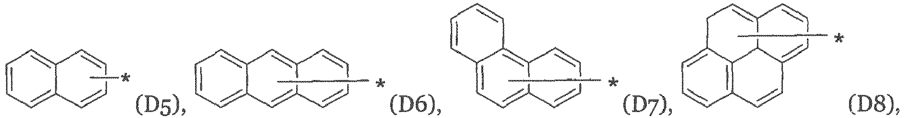 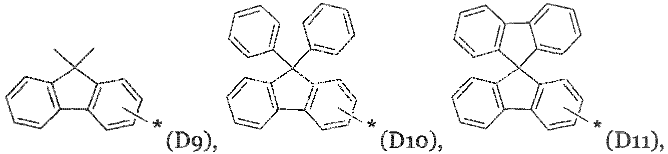 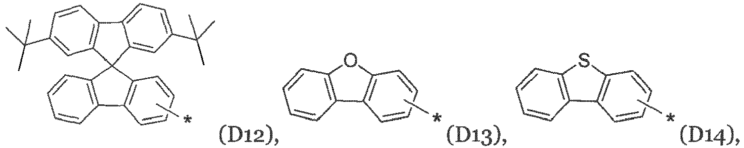 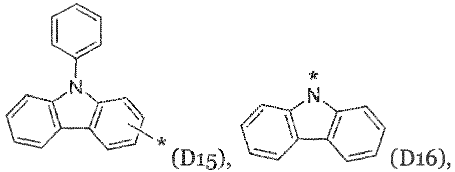 wherein the asterix "*" denotes the binding position.

According to an embodiment, wherein Ar¹, Ar², Ar³, Ar⁴ and Ar⁵ may be independently selected from D1 to D15; alternatively selected from D1 to D10 and D13 to D15.

According to an embodiment, wherein Ar¹, Ar², Ar³, Ar⁴ and Ar⁵ may be independently selected from the group consisting of D1, D2, D5, D7, D9, D10, D13 to D16.

The rate onset temperature may be in a range particularly suited to mass production, when Ar¹, Ar², Ar³, Ar⁴ and Ar⁵ are selected in this range.

The "matrix compound of formula (VI) or formula (VII)" may be also referred to as "hole transport compound".

According to one embodiment, the substantially covalent matrix compound comprises at least one naphthyl group, carbazole group, dibenzofurane group, dibenzothiophene group and/or substituted fluorenyl group, wherein the substituents are independently selected from methyl, phenyl or fluorenyl.

According to an embodiment of the electronic device, wherein the matrix compound of formula (VI) or formula (VII) are selected from F1 to F17:

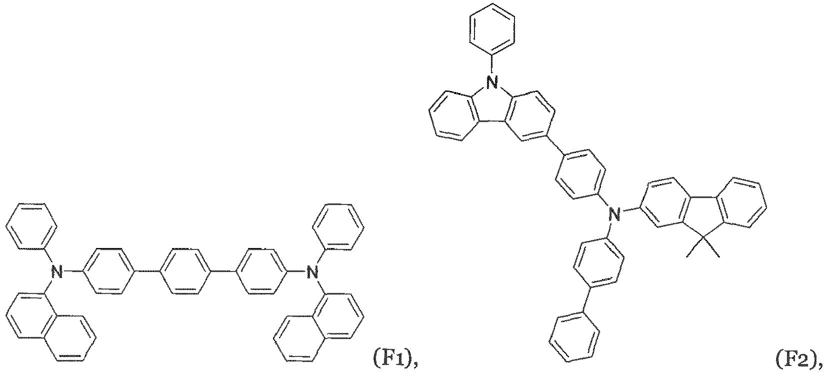

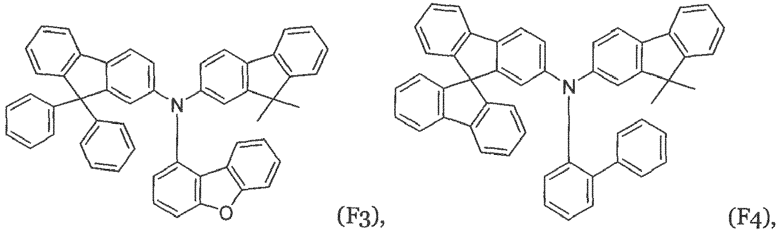

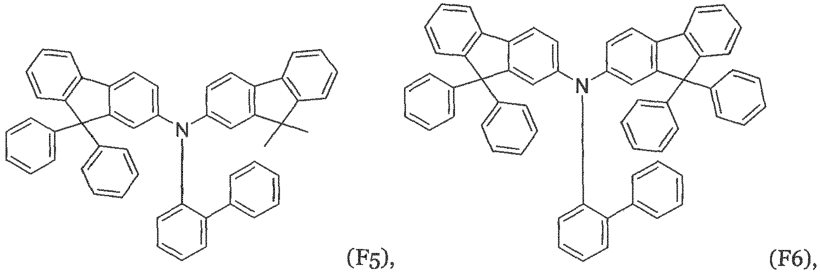

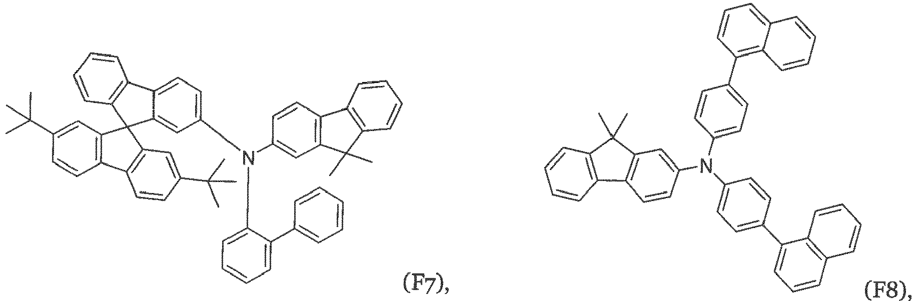

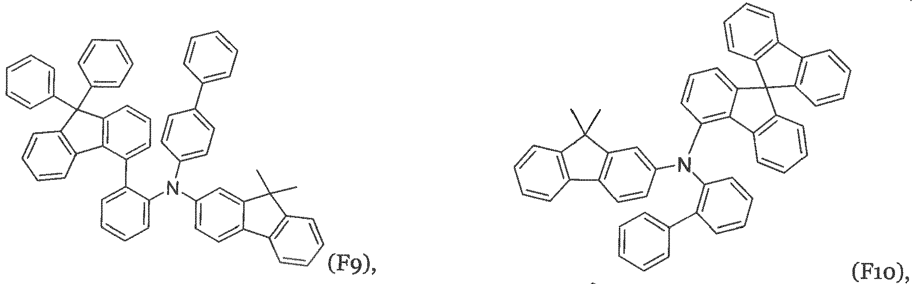

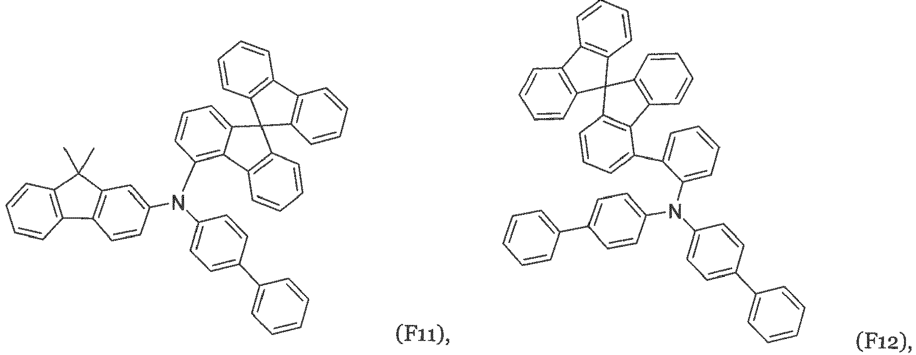

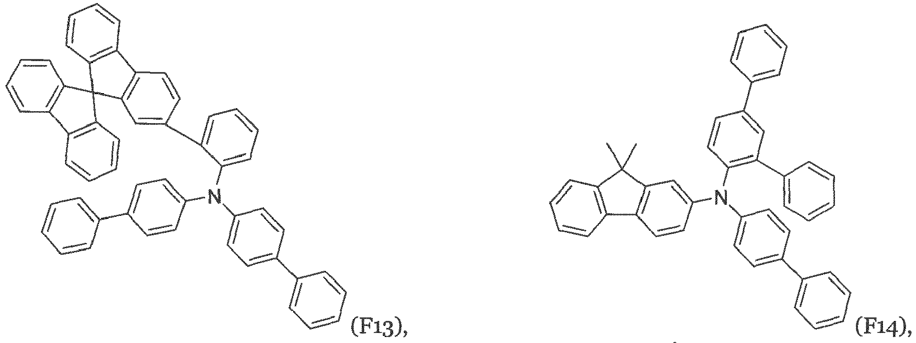

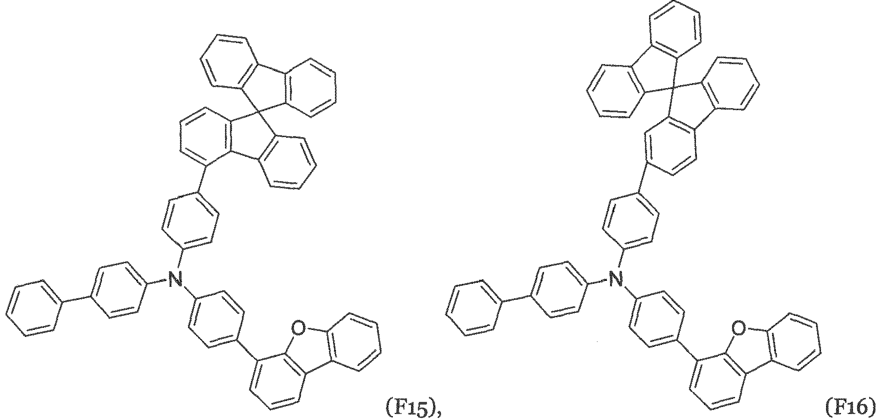

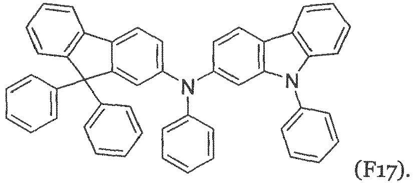

The substantially covalent matrix compound may be free of HTM014, HTM081, HTM163, HTM222, EL-301, HTM226, HTM355, HTM133, HTM334, HTM604 and/or EL-22T. The abbreviations denote the manufacturers' names, for example, of Merck or Lumtec.

According to one embodiment of the invention, at least one semiconductor layer is arranged and/or provided adjacent to the anode layer. According to one embodiment of the invention, at least one semiconductor layer is arranged in direct contact with the anode layer.

According to one embodiment of the invention, at least one semiconductor layer of the present invention is a hole-injection layer.

According to one embodiment of the invention, at least one semiconductor layer is arranged in direct contact with the anode layer consists essentially of the compound of formula (1) to (3) or (5).

In case the at least one semiconductor layer of the present invention is a hole-injection layer and/ or is arranged and/or provided adjacent to the anode layer then it is especially preferred that this layer consists essentially of the compound of formula (1) to (3) or (5).

In the context of the present specification the term "consisting essentially of" especially means and/or includes a concentration of ≥ 90% (vol/vol) more preferred ≥ 95% (vol/vol) and most preferred ≥ 99% (vol/vol).

According to another aspect, the at least one semiconductor layer may have a layer thickness of at least about ≥ 0.5 nm to about ≤ 10 nm, preferably of about ≥ 2 nm to about ≤ 8 nm, also preferred of about ≥ 3 nm to about ≤ 5 nm.

### Further layers

In accordance with the invention, the organic electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

### Anode layer

The anode layer may be formed by depositing or sputtering a material that is used to form the anode electrode. The material used to form the anode electrode may be a high work-function material, so as to facilitate hole injection. The anode material may also be selected from a low work function material (i.e. aluminum). The anode layer may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

According to a preferred embodiment the organic electrode device comprises an anode layer, whereby the anode layer comprises a first anode sub-layer and a second anode sub-layer, wherein
- the first anode sub-layer comprises a first metal having a work function in the range of ≥ 4 and ≤ 6 eV, and
- the second anode sub-layer comprises a transparent conductive oxide; and
- the second anode sub-layer is arranged closer to the hole injection layer.

According to one embodiment of the present invention, the first metal of the first anode sub-layer may be selected from the group comprising Ag, Mg, Al, Cr, Pt, Au, Pd, Ni, Nd, Ir, preferably Ag, Au or Al, and more preferred Ag.

According to one embodiment of the present invention, the first anode sub-layer has have a thickness in the range of 5 to 200 nm, alternatively 8 to 180 nm, alternatively 8 to 150 nm, alternatively 100 to 150 nm.

According to one embodiment of the present invention, the first anode sub-layer is formed by depositing the first metal via vacuum thermal evaporation.

It is to be understood that the first anode layer is not part of the substrate.

According to one embodiment of the present invention, the transparent conductive oxide of the second anode sub layer is selected from the group selected from the group comprising indium tin oxide or indium zinc oxide, more preferred indium tin oxide.

According to one embodiment of the present invention, the second anode sub-layer may have a thickness in the range of 3 to 200 nm, alternatively 3 to 180 nm, alternatively 3 to 150 nm, alternatively 3 to 20 nm.

According to one embodiment of the present invention, the second anode sub-layer may be formed by sputtering of the transparent conductive oxide.

According to one embodiment of the present invention, anode layer of the organic electronic device comprises in addition a third anode sub-layer comprising a transparent conductive oxide, wherein the third anode sub-layer is arranged between the substrate and the first anode sub-layer.

According to one embodiment of the present invention, the third anode sub-layer comprises a transparent oxide, preferably from the group selected from the group comprising indium tin oxide or indium zinc oxide, more preferred indium tin oxide.

According to one embodiment of the present invention, the third anode sub-layer may have a thickness in the range of 3 to 200 nm, alternatively 3 to 180 nm, alternatively 3 to 150 nm, alternatively 3 to 20 nm.

According to one embodiment of the present invention, the third anode sub-layer may be formed by sputtering of the transparent conductive oxide.

It is to be understood that the third anode layer is not part of the substrate.

According to one embodiment of the present invention, the hole injection layer is in direct contact with the anode layer.

### Hole injection layer

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

### Hole transport layer

A hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to one embodiment of the present invention, the hole transport layer may comprise the same substantially covalent matrix compound as the semiconductor layer of the present invention.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime may be improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Photoactive layer (PAL)

The photoactive layer converts an electrical current into photons or photons into an electrical current.

The PAL may be formed on the HTL by vacuum deposition, spin coating, slot-die coat-ing, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

It may be provided that the photoactive layer does not comprise the compound of Formula (1).

The photoactive layer may be a light-emitting layer or a light-absorbing layer.

### Emission layer (EML)

The EML may be formed on the HTL by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

It may be provided that the emission layer does not comprise the compound of Formula (1).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2lrpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The organic electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode electrode

The cathode electrode is formed on the ETL or optional EIL. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

It is to be understood that the cathode electrode is not part of an electron injection layer or the electron transport layer.

### Organic light-emitting diode (OLED)

The organic electronic device according to the invention may be an organic light-emitting device.

According to one aspect of the present invention, there is provided an organic light-emitting diode (OLED) comprising: a substrate; an anode electrode formed on the substrate; an semiconductor layer comprising compound of formula (1) to (3) or (5), a hole transport layer, an emission layer, an electron transport layer and a cathode electrode.

According to another aspect of the present invention, there is provided an OLED comprising: a substrate; an anode electrode layer formed on the substrate; a semiconductor layer comprising a compound of Formula (1) to (3) or (5), a hole transport layer, an electron blocking layer, an emission layer, a hole blocking layer, an electron transport layer and a cathode layer.

According to another aspect of the present invention, there is provided an OLED comprising: a substrate; an anode layer formed on the substrate; a semiconductor layer comprising a compound of Formula (1) to (3) or (5), a hole transport layer, an electron blocking layer, an emission layer, a hole blocking layer, an electron transport layer, an electron injection layer, and a cathode layer.

According to various embodiments of the present invention, there may be provided OLEDs layers arranged between the above mentioned layers, on the substrate or on the top layer.

According to one aspect, the OLED may comprise a layer structure of a substrate that is adjacent arranged to an anode layer, the anode layer is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer, the n-type charge generation layer is adjacent arranged to a hole generating layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode layer an optional electron transport layer and/or an optional injection layer are arranged.

The semiconductor layer according to the invention may be the first hole injection layer and p-type charge generation layer.

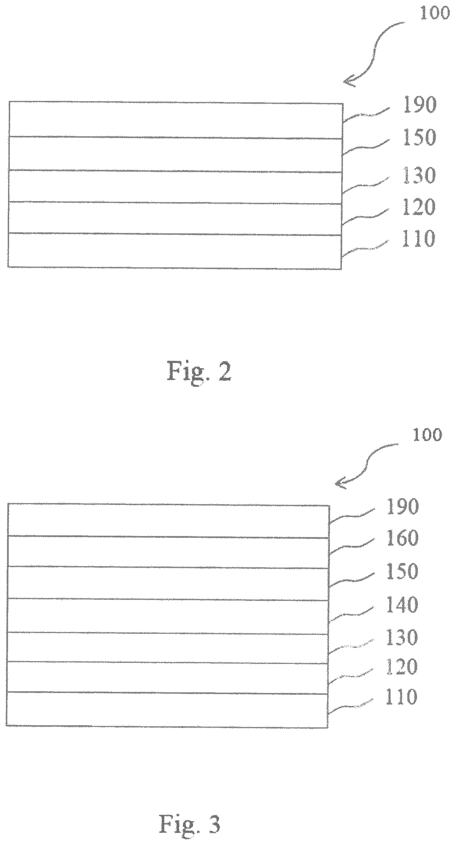

For example, the OLED according to Fig. 2 may be formed by a process, wherein on a substrate (110), an anode layer (120), a hole injection layer (130), a hole transport layer (140), an electron blocking layer (145), an emission layer (150), a hole blocking layer (155), an electron transport layer (160), an electron injection layer (180) and the cathode layer (190) are subsequently formed in that order.

### Method for preparing the organic electronic device

The organic semiconductor layer may be formed on the anode layer or cathode layer by vacuum deposition, spin coating, printing, casting, slot-die coating, Langmuir-Blodgett (LB) deposition, or the like. When the Organic semiconductor layer is formed using vacuum deposition, the deposition conditions may vary according to the compound(s) that are used to form the layer, and the desired structure and thermal properties of the layer. In general, however, conditions for vacuum deposition may include a deposition temperature of 100° C to 350° C, a pressure of 10⁻⁸ to 10⁻³ Torr (1 Torr equals 133.322 Pa), and a deposition rate of 0.1 to 10 nm/sec.

When the organic semiconductor layer is formed using spin coating or printing, coating conditions may vary according to the compound(s) that are used to form the layer, and the desired structure and thermal properties of the organic semiconductor layer. For example, the coating conditions may include a coating speed of about 2000 rpm to about 5000 rpm, and a thermal treatment temperature of about 80° C to about 200° C. Thermal treatment removes a solvent after the coating is performed.

The thickness of the organic semiconductor layer may be in the range from about 1 nm to about 20 nm, and for example, from about 2 nm to about 15 nm, alternatively about 2 nm to about 12 nm.

When the thickness of the organic semiconductor layer is within this range, the organic semiconductor layer may have excellent hole injecting and/or hole generation characteristics, without a substantial penalty in driving voltage.

According to another aspect of the present invention, there is provided a method comprising the step of applying said compound of formula (1) to (3) or (5) on a surface.

According to one embodiment of the invention, the method comprises fabricating the organic electronic device according to the invention by depositing a compound of formula (1) to (3) or (5) between the anode and least one photoactive layer preferably onto the anode layer, more preferably onto the surface of the anode layer

According to another aspect of the present invention, there is provided a method of manufacturing an organic electronic device, the method using:
- at least one deposition source, preferably two deposition sources and more preferred at least three deposition sources.

The methods for deposition that can be suitable comprise:
- deposition via vacuum thermal evaporation;
- deposition via solution processing, preferably the processing is selected from spin-coating, printing, casting; and/or
- slot-die coating.

According to various embodiments of the present invention, there is provided a method using:
- a first deposition source to release the compound of Formula (1) to (3) or (5) according to the invention, and
- a second deposition source to release the substantially covalent matrix compound;
the method comprising the steps of forming the semiconductor layer; whereby for an organic light-emitting diode (OLED):
- the semiconductor layer is formed by releasing the compound of Formula (1) to (3) or (5) according to the invention from the first deposition source and the substantially covalent matrix compound from the second deposition source.

According to various embodiments of the present invention, the method may further include forming on the anode layer, at least one layer selected from the group consisting of forming a hole transport layer or forming a hole blocking layer, and an emission layer between the anode layer and the first electron transport layer. Preferably, the compound of formula (1) to (3) or (5) is deposited from the gas phase. Method comprising a further step of transferring a compound of formula (1) to (3) or (5) from the solid state into the gas phase. Preferably, the source is a vacuum thermal evaporation (VTE) source. Preferably, the compound of formula (1) to (3) or (5) is transferred from solid state into the gas phase from a first VTE source and the compound of formula (1) to (3) or (5) is transferred from the solid state into the gas phase from a second source.

According to various embodiments of the present invention, the method may further include the steps for forming an organic light-emitting diode (OLED), wherein
- on a substrate an anode layer is formed,
- on the anode layer a semiconductor layer comprising a compound of formula (1) to (3) or (5) is formed,
- on the semiconductor layer comprising a compound of formula (1) to (3) or (5) a hole transport layer is formed,
- on the hole transport layer an emission layer is formed,
- on the emission layer an electron transport layer is formed, optionally a hole blocking layer is formed on the emission layer,
- and finally a cathode layer is formed,
- optional a hole blocking layer is formed in that order between the first anode layer and the emission layer,
- optional an electron injection layer is formed between the electron transport layer and the cathode layer.

According to various embodiments, the OLED may have the following layer structure, wherein the layers having the following order:
anode, semiconductor layer comprising a compound of Formula (1) to (3) or (5) according to the invention, first hole transport layer, second hole transport layer, emission layer, optional hole blocking layer, electron transport layer, optional electron injection layer, and cathode.

### Display device

The present invention furthermore relates to a display device comprising an organic electronic device according to the present invention.

### Compound

The present invention furthermore relates to a represented by formula (3) 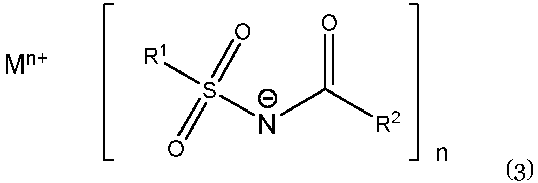 wherein
- M is main group metal, or a transition metal;
- n is an integer from 1 to 4, preferably 1 or 2;
- R¹ is independently selected from an unsubstituted C₁ to C₈ alkyl, a partially or perfluorinated C₂ to C₈ alkyl, a substituted or unsubstituted C₆ to C₂₀ aryl, a substituted or unsubstituted C₂ to C₂₀ heteroaryl, a substituted or unsubstituted C₃ to C₂₀ carbocyclyl, or a substituted or unsubstituted C₂ to C₂₀ heterocyclyl;
- R² is independently selected from a substituted or unsubstituted C₁ to C₈ alkyl, substituted or unsubstituted C₆ to C₂₀ aryl, a substituted or unsubstituted C₂ to C₂₀ heteroaryl, a substituted or unsubstituted C₃ to C₂₀ carbocyclyl, or substituted or unsubstituted C₂ to C₂₀ heterocyclyl;
- if at least one of R¹ and R² is aryl or heteroaryl and at least one of the aryl and the heteroaryl is substituted, then the one or more substituent(s) on aryl and heteroaryl is/are independently selected from F, CN, or a partially or perfluorinated C₁ to C₈ alkyl; and
- the following compounds are excluded: 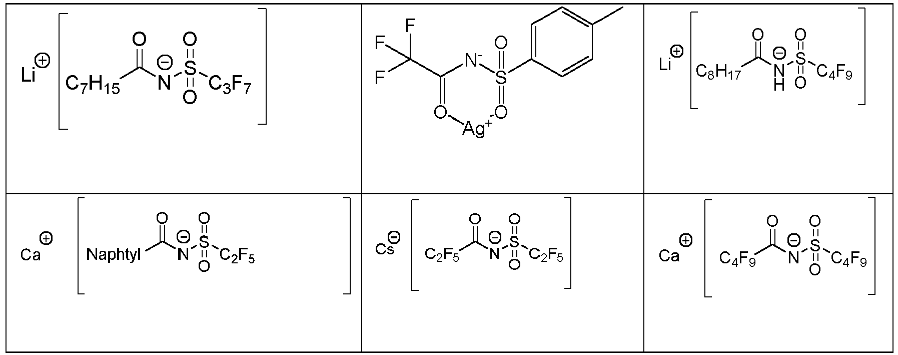 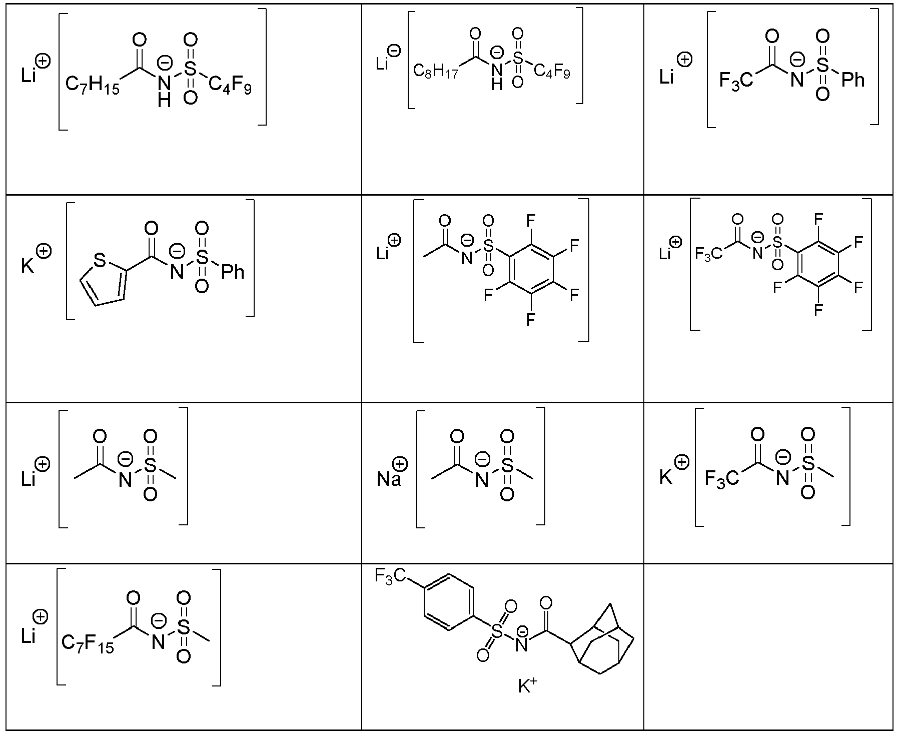 and compounds are excluded which are represented by the formula (4) 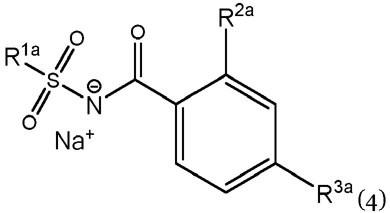 wherein
   R^{1a} is pyridyl which is optionally substituted one to three times by a)-O-phenyl, wherein the phenyl is one or two times substituted by halogen, cyano, alkyl, alkoxy, nitro, amino, alkylamino or dialkylamino; b) -NRR', wherein R and R' independently represent hydrogen or alkyl; or alternatively R and R' form together with the nitrogen atom to which they are attached a saturated 5 to 7 membered heterocycle, which is optionally substituted one to three times by alkyl or alkoxy; c) halogen; or d) alkyl; R^{2a} is fluorine, chlorine, bromine, methyl, methoxy or trifluoromethyl; R^{3a} is fluorine, chlorine, bromine, methyl or trifluoromethyl.

According to one embodiment of the invention
- M has an atomic weight of more than 7; R¹ is independently selected from perfluorinated C₂ to C₈ alkyl; and R² is independently selected from unsubstituted C₁ to C₈ alkyl;
   or
- M is a main group metal except Li, Na, Ca and Cs, or a transition metal; R¹ is independently selected from perfluorinated C₂ to C₈ alkyl; and R² is independently selected from a partially fluorinated and perfluorinated C₁ to C₈ alkyl;
   or
- R¹ is independently selected from partially fluorinated C₂ to C₈ alkyl;
   or
- M is a main group metal except Na and Ca, or a transition metal; R¹ is independently selected from partially fluorinated or perfluorinated C₂ to C₈ alkyl; and R² is independently selected from substituted or unsubstituted C₆ to C₂₀ aryl, or substituted or unsubstituted C₂ to C₂₀ heteroaryl;
   or
- M is a main group metal, or a transition metal; R¹ is independently selected from partially fluorinated or perfluorinated C₂ to C₈ alkyl; and R² is independently selected from substituted C₆ to C₂₀ aryl, or substituted C₂ to C₂₀ heteroaryl, wherein the one or more substituents on the aryl and/or heteroaryl are independently F or CF₃;
   or
- M has an atomic weight of more than 7; R¹ is independently selected from unsubstituted C₁ to C₈ alkyl; and R² is independently selected from a substituted or unsubstituted C₂ to C₈ alkyl, substituted or unsubstituted C₆ to C₂₀ aryl, or substituted or unsubstituted C₂ to C₂₀ heteroaryl;
   or
- M has an atomic weight of more than 7; R¹ is independently selected from substituted or unsubstituted C₆ to C₂₀ aryl, or substituted or unsubstituted C₂ to C₂₀ heteroaryl; and R² is independently selected from a substituted or unsubstituted C1 to C₈ alkyl, substituted or unsubstituted C₆ to C₂₀ aryl, or substituted or unsubstituted C₂ to C₂₀ heteroaryl; with the provisio that

(a) if R₁ is unsubstituted phenyl, unsubstituted tolyl, or perfluorinated phenyl then M is not Ag,
(b) if R₁ is pyridyl, and R² is 2,4-substituted phenyl then M is not Na, and
(c) if R¹ is unsubstituted phenyl and R² is thiophenyl then M is not K.

Preferred embodiments described herein with respect to compounds (1) to (3) in context of the organic electronic device are also preferred embodiments of the compound per se as long as the embodiments are encompassed by the definition of the compound.

According to one embodiment of the present invention, there is provided a compound represented by formula (3) 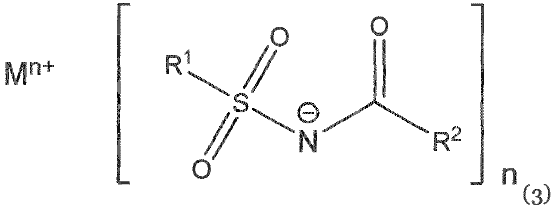 wherein
- M has an atomic weight of more than 7; R¹ is independently selected from perfluorinated C₂ to C₈ alkyl; and R² is independently selected from unsubstituted C₁ to C₈ alkyl;
   or
- M is a main group metal except Li, Na, Ca and Cs, or a transition metal; R¹ is independently selected from perfluorinated C₂ to C₈ alkyl; and R² is independently selected from a partially fluorinated and perfluorinated C₁ to C₈ alkyl;
   or
- R¹ is independently selected from partially fluorinated C₂ to C₈ alkyl;
   or
- M is a main group metal except Na and Ca, or a transition metal; R¹ is independently selected from partially fluorinated or perfluorinated C₂ to C₈ alkyl; and R² is independently selected from substituted or unsubstituted C₆ to C₂₀ aryl, or substituted or unsubstituted C₂ to C₂₀ heteroaryl;
   or
- M is a main group metal, or a transition metal; R¹ is independently selected from partially fluorinated or perfluorinated C₂ to C₈ alkyl; and R² is independently selected from substituted C₆ to C₂₀ aryl, or substituted C₂ to C₂₀ heteroaryl, wherein the one or more substituents on the aryl and/or heteroaryl are independently F or CF₃;
   or
- M has an atomic weight of more than 7; R¹ is independently selected from unsubstituted C₁ to C₈ alkyl; and R² is independently selected from a substituted or unsubstituted C₂ to C₈ alkyl, substituted or unsubstituted C₆ to C₂₀ aryl, or substituted or unsubstituted C₂ to C₂₀ heteroaryl;
   or
- M has an atomic weight of more than 7; R¹ is independently selected from substituted or unsubstituted C₆ to C₂₀ aryl, or substituted or unsubstituted C₂ to C₂₀ heteroaryl; and R² is independently selected from a substituted or unsubstituted C1 to C₈ alkyl, substituted or unsubstituted C₆ to C₂₀ aryl, or substituted or unsubstituted C₂ to C₂₀ heteroaryl; with the provisio that

(a) if R¹ is unsubstituted phenyl, unsubstituted tolyl, or perfluorinated phenyl then M is not Ag,
(b) if R¹ is pyridyl, and R² is 2,4-substituted phenyl then M is not Na, and
(c) if R¹ is unsubstituted phenyl and R² is thiophenyl then M is not K.

### Metal

According to one embodiment of the present invention, the metal M is selected from an alkali metal, alkaline earth metal, transition metal.

According to one embodiment of the present invention, the metal M is selected from alkali metals, alkaline earth metals, Pb, Mn, Fe, Co, Ni, Cu, Zn, Ag Cd, Al, Ga, In, Sn, Ti, Zr, Hf, V, Nb, Ta, Cr, Mo and W.

According to one embodiment of the present invention, the metal M is selected from alkaline earth metals, Pb, Mn, Fe, Co, Ni, Cu, Zn, Ag Cd, Sn, Ti, Zr, Hf, V, Nb, Ta, Cr, Mo and W.

According to one embodiment of the present invention, the metal M is selected from an alkali metal, an alkaline earth metal, Cu, Ag, Fe, Co, Ti, Zr, Hf, Mo, or W.

According to one embodiment of the present invention, the metal M is selected from Na, Cu, or Ag.

### R¹ and R¹

According to one embodiment of the present invention, R¹ is independently selected from an unsubstituted C₁ to C₈ alkyl, partially or perfluorinated C₂ to C₈ alkyl, substituted or unsubstituted C₆ to C₂₀ aryl, substituted or unsubstituted C₂ to C₂₀ heteroaryl.

According to one embodiment of the present invention, R¹ is independently selected from perfluorinated propyl, perfluorinated butyl, or 3,5-bis(trifluormethyl)phenyl.

According to one embodiment of the present invention, R¹ is independently selected from branched or unbranched C₃F₇ or C₄F.

According to one embodiment of the present invention, R² is independently selected from a substituted or unsubstituted C₁ to C₈ alkyl, substituted or unsubstituted C₆ to C₂₀ aryl, or substituted or unsubstituted C₂ to C₂₀ heteroaryl.

According to one embodiment of the present invention, R² is independently selected from perfluorinated propyl, perfluorinated butyl, or 3,5-bis(trifluormethyl)phenyl.

### Electron withdrawing group

According to one embodiment of the present invention, if at least one of R¹ and R² is substituted then at least one substituent on R1 and/or R2 is an electron-withdrawing group.

According to one embodiment of the present invention, at least one of R¹ and R² is substituted and at least one substituent on R¹ and/or R² is an electron-withdrawing group.

According to one embodiment of the present invention, at least one of R¹ and R² is substituted and at least one substituent on R¹ and/or R² is an electron-withdrawing group, wherein the electron-withdrawing group is independently selected from halogen, Cl, F, CN, a partially fluorinated or perfluorinated C₁ to C₁₀ alkyl, partially fluorinated or perfluorinated C₆ to C₂₀, aryl, and partially fluorinated or perfluorinated C₂ to C₂₀ heteroaryl.

According to one embodiment of the present invention, at least one of R¹ and R² is substituted and at least one substituent on R¹ and/or R² is an electron-withdrawing group, wherein the electron-withdrawing group is independently selected F, CN, partially or perfluorinated C₁ to C₈ alkyl.

According to one embodiment of the present invention, R¹ is independently selected from an unsubstituted C₁ to C₈ alkyl, partially or perfluorinated C₂ to C₈ alkyl, substituted or unsubstituted C₆ to C₂₀ aryl, substituted or unsubstituted C₂ to C₂₀ heteroaryl, substituted or unsubstituted C₃ to C₂₀ carbocyclyl, substituted or unsubstituted C₂ to C₂₀ heterocyclyl;
R² is independently selected from a substituted or unsubstituted C₁ to C₈ alkyl, substituted or unsubstituted C₆ to C₂₀ aryl, or substituted or unsubstituted C₂ to C₂₀ heteroaryl, substituted or unsubstituted C₃ to C₂₀ carbocyclyl, substituted or unsubstituted C₂ to C₂₀ heterocyclyl;
wherein the substituent on aryl and heteroaryl is independently selected from F, CN, partially or perfluorinated C₁ to C₈ alkyl.

According to one embodiment of the present invention R¹ is independently selected from an unsubstituted C₁ to C₈ alkyl, partially or perfluorinated C₂ to C₈ alkyl, substituted or unsubstituted C₆ to C₂₀ aryl, substituted or unsubstituted C₂ to C₂₀ heteroaryl, substituted or unsubstituted C₃ to C₂₀ carbocyclyl, substituted or unsubstituted C₂ to C₂₀ heterocyclyl;
R² is independently selected from a substituted or unsubstituted C₁ to C₈ alkyl, substituted or unsubstituted C₆ to C₂₀ aryl, or substituted or unsubstituted C₂ to C₂₀ heteroaryl, substituted or unsubstituted C₃ to C₂₀ carbocyclyl, substituted or unsubstituted C₂ to C₂₀ heterocyclyl;
wherein the substituent on aryl and heteroaryl is independently selected from F, CN, partially or perfluorinated C₁ to C₈ alkyl.

According to one embodiment of the present invention, R¹ is independently selected from an unsubstituted C₁ to C₈ alkyl, partially or perfluorinated C₂ to C₈ alkyl, substituted or unsubstituted C₆ to C₂₀ aryl, substituted or unsubstituted C₂ to C₂₀ heteroaryl;
R² is independently selected from a substituted or unsubstituted C₁ to C₈ alkyl, substituted or unsubstituted C₆ to C₂₀ aryl, or substituted or unsubstituted C₂ to C₂₀ heteroaryl;
if there is a substituent on aryl and heteroaryl the substituent is independently selected from F, CN, partially or perfluorinated C₂ to C₈ alkyl, and substituted or unsubstituted aryl, substituted or unsubstituted heteroaryl, preferably the substituent on aryl and heteroaryl is independently selected from F, CN, partially or perfluorinated C₁ to C₈ alkyl.

### Further embodiments

According to one embodiment of the present invention, there is provided a compound represented by formula (3) 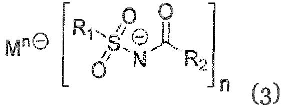 wherein
- M is selected from Cu, Na or Ag;
- n is an integer from 1 or 2; and
- R¹ and R² are independently selected from perfluorinated propyl, perfluorinated butyl, or 3,5-bis(trifluormethyl)phenyl.

### Compounds

According to one embodiment of the present invention, the compound is selected from B-1 and B-3 to B-8

| | |
|---|---|
| 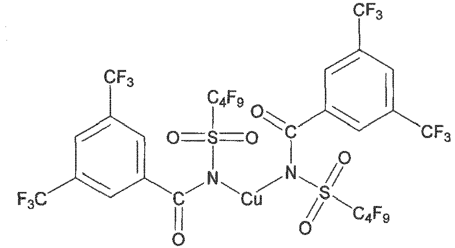 | |
| B-1 | |
| 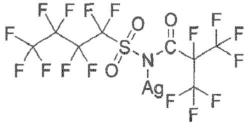 | 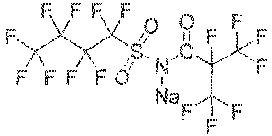 |
| B-3 | B-4 |
| 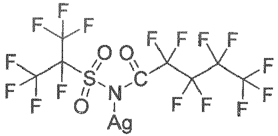 | 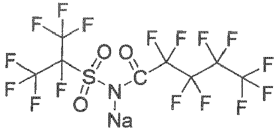 |
| B-5 | B-6 |
| 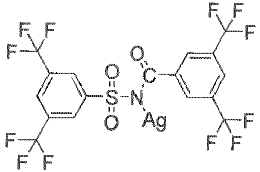 | 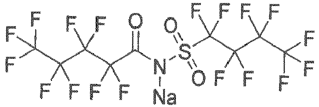 |
| B-7 | B-8 |

The present invention furthermore relates to a compound represented by formula (5) 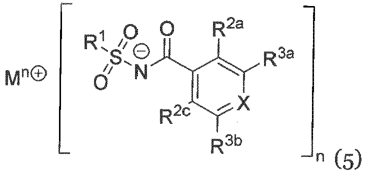 wherein
- M is a metal;
- n is an integer from 1 to 4, preferably 1 or 2;
- X is N or C-R^{2b};
- R¹ is selected from a partially or perfluorinated C₁ to C₈ alkyl, a substituted phenyl or unsubstituted or substituted C₃ to C₅ heteroaryl, wherein the substituents are selected from fluorine, chlorine, bromine, methyl, methoxy or trifluoromethyl, or CN;
- R^{2a}, R^{2b}, and R^{2c} are independently selected from fluorine, chlorine, bromine, methyl, methoxy or trifluoromethyl, or CN; and
- R^{3a} and R^{3b} are independently selected from a partially or perfluorinated C₁ to C₈ alkyl, or CN.

According to one embodiment of the present invention, the metal M is selected from an alkali metal, alkaline earth metal, and transition metal.

According to one embodiment of the present invention, the metal M is selected from alkali metals, alkaline earth metals, Pb, Mn, Fe, Co, Ni, Cu, Zn, Ag Cd, Al, Ga, In, Sn, Ti, Zr, Hf, V, Nb, Ta, Cr, Mo and W.

According to one embodiment of the present invention, the metal M is selected from alkaline earth metals, Pb, Mn, Fe, Co, Ni, Cu, Zn, Ag Cd, Sn, Ti, Zr, Hf, V, Nb, Ta, Cr, Mo and W.

According to one embodiment of the present invention, the metal M is selected from an alkali metal, an alkaline earth metal, Cu, Ag, Fe, Co, Ti, Zr, Hf, Mo, or W.

According to one embodiment of the present invention, the metal M is selected from Na, Cu, or Ag, preferably is Cu or Ag.

According to one embodiment of the present invention, R^{2a}, R^{2b}, and R^{2c} are selected from a partially or perfluorinated C₃ to C₄ alkyl, a substituted phenyl or unsubstituted or substituted C₃ to C₅ heteroaryl, wherein the substituents are in the 3-position and in the 5-position and selected from fluorine, trifluoromethyl, or CN.

According to one embodiment of the present invention, R^{3a} and R^{3b} are independently selected from CF₃ or CN.

### DESCRIPTION OF THE DRAWINGS

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.
FIG. 1 is a schematic sectional view of an organic electronic device, according to an exemplary embodiment of the present invention;
FIG. 2 is a schematic sectional view of an organic light-emitting diode (OLED), according to an exemplary embodiment of the present invention;
FIG. 3 is a schematic sectional view of an organic light-emitting diode (OLED), according to an exemplary embodiment of the present invention.
FIG. 4 is a schematic sectional view of an organic light-emitting diode (OLED), according to an exemplary embodiment of the present invention;
FIG. 5 is a schematic sectional view of an organic light-emitting diode (OLED), according to an exemplary embodiment of the present invention.
FIG. 6 is a schematic sectional view of an organic light-emitting diode (OLED), according to an exemplary embodiment of the present invention.

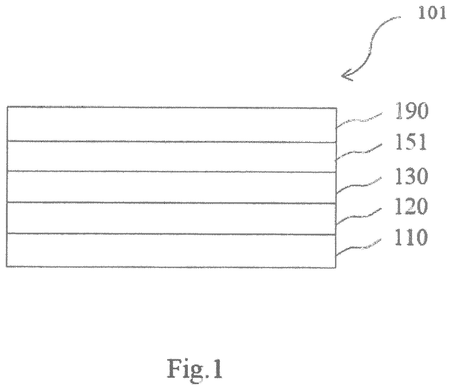

Hereinafter, the figures 1 to 6 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device 101, according to an exemplary embodiment of the present invention. The organic electronic device 101 includes a substrate (no), an anode layer (120), a semiconductor layer comprising a compound of Formula (1) to (3) or (5) (130), a photoactive layer (PAL) (151) and a cathode layer (190).

FIG. 2 is a schematic sectional view of an organic light-emitting diode (OLED) 100, according to an exemplary embodiment of the present invention. The OLED 100 includes a substrate (no), an anode layer (120), a semiconductor layer comprising a compound of Formula (1) to (3) or (5) (130), an emission layer (EML) (150) and a cathode layer (190).

FIG. 3 is a schematic sectional view of an organic light-emitting diode (OLED) 100, according to an exemplary embodiment of the present invention. The OLED 100 includes a substrate (no), an anode layer (120), a semiconductor layer comprising a compound of Formula (1) to (3) or (5) (130), a hole transport layer (HTL) (140), an emission layer (EML) (150), an electron transport layer (ETL) (160) and a cathode layer (190).

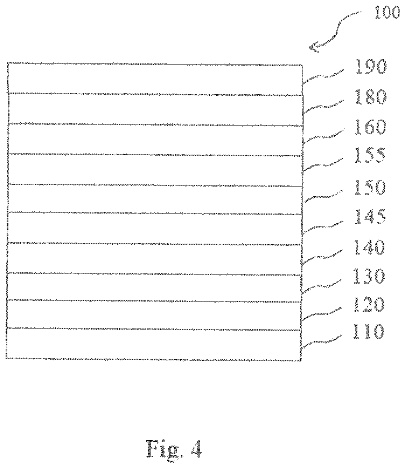

FIG. 4 is a schematic sectional view of an organic light-emitting diode (OLED) 100, according to an exemplary embodiment of the present invention. The OLED 100 includes a substrate (no), an anode layer (120), a semiconductor layer comprising a compound of Formula (1) to (3) or (5) (130), a hole transport layer (HTL) (140), an electron blocking layer (EBL) (145), an emission layer (EML) (150), a hole blocking layer (HBL) (155), an electron transport layer (ETL) (160), an optional electron injection layer (EIL) (180), and a cathode layer (190).

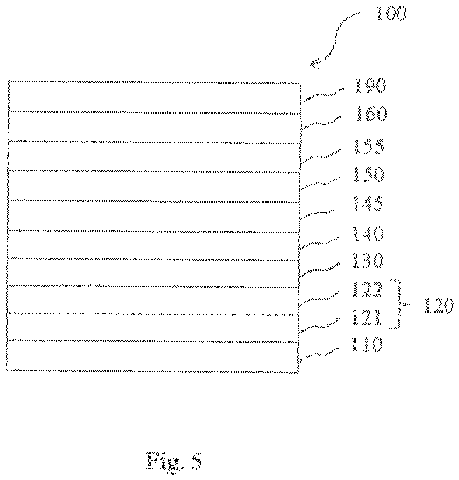

FIG. 5 is a schematic sectional view of an organic light-emitting diode (OLED) 100, according to an exemplary embodiment of the present invention. The OLED 100 includes a substrate (110), an anode layer (120) that comprises a first anode sub-layer (121) and a second anode sub-layer (122), a semiconductor layer comprising compound of Formula (1) to (3) or (5) (130), a hole transport layer (HTL) (140), an electron blocking layer (EBL) (145), an emission layer (EML) (150), a hole blocking layer (EBL) (155), an electron transport layer (ETL) (160) and a cathode layer (190).

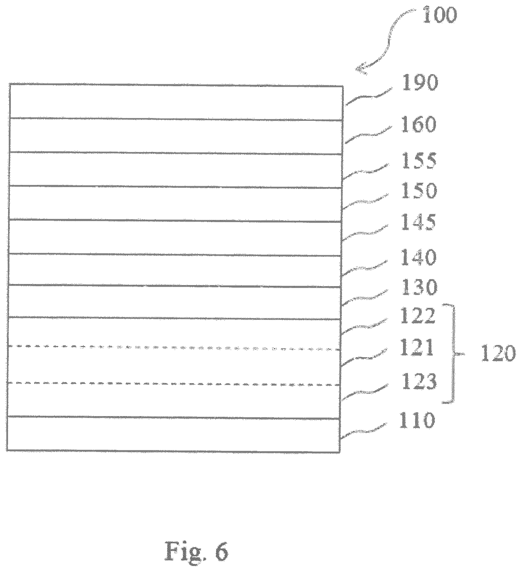

FIG. 6 is a schematic sectional view of an organic light-emitting diode (OLED) 100, according to an exemplary embodiment of the present invention. The OLED 100 includes a substrate (110), an anode layer (120) that comprises a first anode sub-layer (121), a second anode sub-layer (122) and a third anode sub-layer (123), a semiconductor layer comprising compound of Formula (1) to (3) or (5) (130), a hole transport layer (HTL) (140), an electron blocking layer (EBL) (145), an emission layer (EML) (150), a hole blocking layer (EBL) (155), an electron transport layer (ETL) (160) and a cathode layer (190). The layers are disposed exactly in the order as mentioned before.

In the description above the method of manufacture an organic electronic device 101 of the present invention is for example started with a substrate (no) onto which an anode layer (120) is formed, on the anode layer (120), a semiconductor layer comprising compound of Formula (1) to (3) or (5) (130), a photoactive layer (151) and a cathode electrode 190 are formed, exactly in that order or exactly the other way around.

In the description above the method of manufacture an OLED 100 of the present invention is started with a substrate (no) onto which an anode layer (120) is formed, on the anode layer (120), a semiconductor layer comprising compound of Formula (1) to (3) or (5) (130), optional a hole transport layer (140), optional an electron blocking layer (145), an emission layer (150), optional a hole blocking layer (155), optional an electron transport layer (160), optional an electron injection layer (180), and a cathode electrode 190 are formed, exactly in that order or exactly the other way around.

The semiconductor layer comprising a compound of Formula (1) to (3) or (5) (130) can be a hole injection layer.

While not shown in Fig. 1 to Fig. 6, a capping layer and/or a sealing layer may further be formed on the cathode electrodes 190, in order to seal the OLEDs 100. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

### DETAILED DESCRIPTION

The invention is furthermore illustrated by the following examples which are illustrative only and non-binding.

### Ligand synthesis

### Synthesis of the protonated ligand N-((perfluorobutyl)sulfonyl)-3,5-bis(trifluoromethyl)benzamide for B1

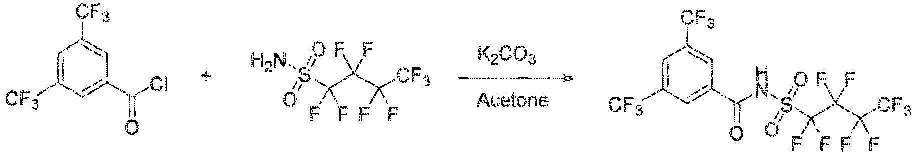

To a mixture of 3.05 g (1.0 eq) of carbonyl chloride and 4.56 g (3.0 eq) potassium carbonate in a baked out Schlenk-flask 30 ml dry acetone were added. The mixture was cooled in an ice-bath and 3.29 g (1.0 eq) sulphonamide were added. The reaction was stirred at room temperature for 2 days. The solid was filtered off and the solvent removed under reduced pressure. The crude product was treated with 300ml 30% sulphuric acid and extracted portion wise with diethyl ether. The combined organic layers were washed with water and the solvent removed under reduced pressure. The crude product was slurry washed two times with chloroform. Yield: 3.34 g (57%)

### Synthesis of the protonated ligand 2,3,3,3-tetrafluoro-N-(perfluoropropyl)sulfonyl)-2-(trifluoromethyl)propanamide for B3 and B4

### 1^{st} Step: 2,3,3,3-tetrafluoro-2-(trifluoromethyl)propanamide

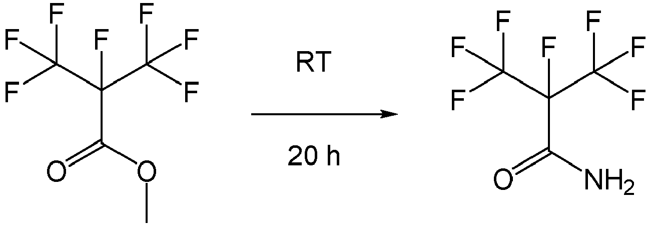

A mixture of 4.99 g (21.9 mmol) methyl 2,3,3,3-tetrafluoro-2-(trifluoromethyl)propanoate and 63 ml of a 7 M solution of NH₃ in MeOH was stirred together under argon at room temperature for 20 h.Then the solvents were distilled off and the residue was triturated in 50 ml hexane, filtered, washed with 2× 25 ml hexane and dried.
Yield: 3.27 g (70%) white solid

### 2^{nd} Step: 2,3,3,3-tetrafluoro-N-((perfluorobutyl)sulfonyl)-2-(trifluoromethyl)propanamide

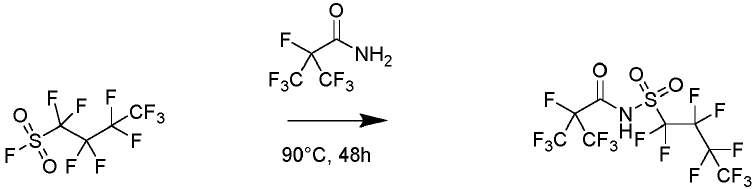

A mixture of 5.33 g (25 mmol) 2,3,3,3-tetrafluoro-2-(trifluoromethyl)propanamide, 7.55 g (25 mmol) 1,1,2,2,3,3,4,4,4-nonafluorobutane-1-sulfonyl fluoride and 20 ml of triethylamine was stirred at 90°C for 48 h. After cooling the reaction mixture was concentrated and the residue dissolved in 500 ml of DCM. The DCM-solution washed with 3× 150ml of water, dried (Na₂SO₄) and concentrated. The resulting brownish oil (3.74g ,92%) of product-triethylammonium salt was stirred in a sublimation setup with 12.5 ml of conc. H₂SO₄. The free acid product was sublimed off in a fine vacuum and was sublimed again at 55°C to give the title compound. Yield: 10.06 g (80%) white solid

### Synthesis of the protonated ligand 2,2,3,3,4,4,5,5,5-nonafluoro-N-((perfluoropropan-2-yl)sulfonyl)pentanamide for B5 and B6

### 1^{st} Step: Synthesis of triethylammonium 2,2,3,3,4,4,5,5,5-nonafluoro-N-((perfluoropropan-2-yl)sulfonyl)pentanamide

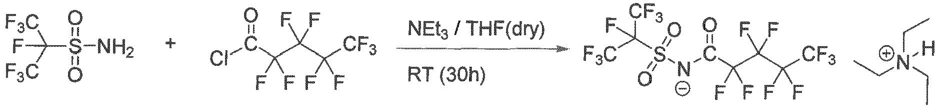

To a solution of 3.99 g (1 eq) sulphonyl amide and 4.44 mL (2 eq) trimethylamine in 80 mL dry THF the 4.89 g (1.05 eq) sulfonyl chloride was added dropwise at 0°C. The mixture was stirred at RT for 30 h. The reaction mixture was diluted with 200 mL water and extracted two times with 300 mL dichloromethane. The combined organic phases were washed with 100 ml water, dried over sodium sulphate and concentrated. Yield: 9.15g (96%)

### 2^{nd} Step: Synthesis of 2,2,3,3,4,4,5,5,5-nonafluoro-N-((perfluoropropan-2-yl)sulfonyl)pentanamide

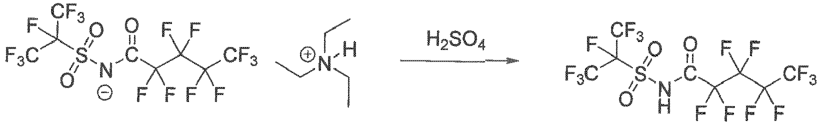

8.3 mL (10 eq) sulfuric acid (98%) was added to the ammonium salt and the mixture was stirred in a distillation apparatus at 70°C. The product was collected at 38-40°C in high vacuum (0.05 mbar) as a colourless oil. Yield: 6.67 g (88%)

### Synthesis of compound B1 bis(N-((perfluorobutyl)sulfonyl)-3,5-bis(trifluoromethyl) benzamido)copper

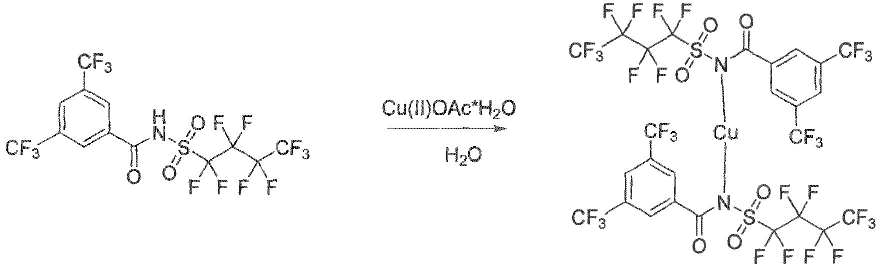

3.13 g (2.05 eq) of the starting material was suspended in 15 mL water and 0.57 g (1.0 eq) copper acetate were added. The resulting mixture was stirred at room temperature for 2h. Two phases formed, and after separation the organic phase was washed with water. The solvent was evaporated and the residue was dried in high vacuum at 8o°C. Yield. 2.75g (85%)

### Synthesis of compound B3 (2,3,3,3-tetrafluoro-N-((perfluorobutyl)sulfonyl)-2-(trifluoromethyl)propanamido)silver

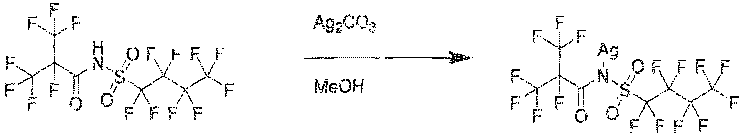

To a solution of 2.5 g (5.05 mmol) of 2,3,3,3-tetrafluoro-N-((perfluorobutyl)sulfonyl)-2-(trifluoromethyl)propanamide in 30 ml MeOH was added 0.84 g (3 mmol) Ag₂CO₃. The resulting suspension was stirred over night at room temperature, then filtered and the clear filtrate was evaporate to dryness and was further dried overnight in vacuum. Yield: 2.90 (95%), white powder.

### Synthesis of compound B4 Sodium ((perfluorobutyl)sulfonyl)(2,3,3,3-tetrafluoro-2-(trifluoromethyl)propanoyl)amide

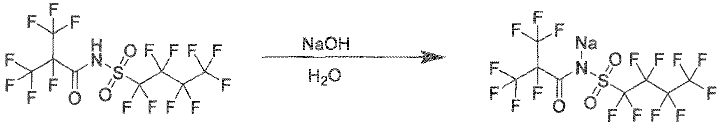

To a solution of 2.5 g (5.05 mmol) of ((perfluorobutyl)sulfonyl)(2,3,3,3-tetrafluoro-2-(trifluoromethyl)propanoyl)amide in 10 ml of water was added a 1 M solution of NaOH until pH was neutral (pH-paper). The resulting solution was evaporated to dryness. The white solid residue was dried overnight in vacuum. Yield: 2.41g (92%), white powder.

### Synthesis of compound B5 (2,2,3,3,4,4,5,5-nonafluoro-N-((perfluoropropan-2-yl)sulfonyl)pentanamido)silver

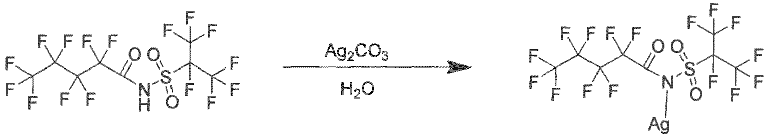

To a solution of 1.55 g (3.13 mmol) 2,2,3,3,4,4,5,5,5-nonafluoro-N-((perfluoropropan-2-yl)sulfonyl)pentanamide in 20ml of water was added 0.7 g (2.5 mmol) of Ag₂CO₃. The resulting suspension was stirred over night at room temperature, then filtered and the clear filtrate evaporated to dryness to give white crystals, which were dried overnight in vacuum. Yield: 1.66g (88%).

### Synthesis of compound B6 sodium (2,2,3,3,4,4,5,5-nonafluoropentanoyl)((perfluoropropan-2-yl)sulfonyl)amide

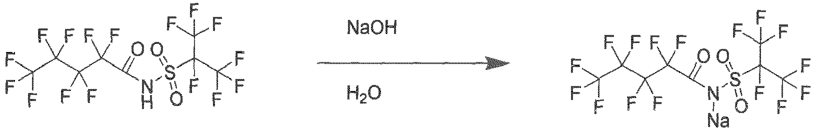

To a solution of 1.26 g (2.54 mmol) of 2,2,3,3,4,4,5,5,5-nonafluoropentanoyl)((perfluoropropan-2-yl)sulfonyl)amide in 20 ml of water was added a solution of 100 mg (2.5 mmol) NaOH in 3 ml of water dropwise until pH of solution was neutral (pH-paper). The solution was evaporated to dryness and dried further overnight in vacuum. Yield: 1.04 g (77%), white powder.

### Sublimation temperature

Under nitrogen in a glovebox, 0.5 to 5 g compound are loaded into the evaporation source of a sublimation apparatus. The sublimation apparatus consists of an inner glass tube consisting of bulbs with a diameter of 3 cm which are placed inside a glass tube with a diameter of 3.5 cm. The sublimation apparatus is placed inside a tube oven (Creaphys DSU 05/2.1). The sublimation apparatus is evacuated via a membrane pump (Pfeiffer Vacuum MVP 055- 3C) and a turbo pump (Pfeiffer Vacuum THM071 YP). The pressure is measured between the sublimation apparatus and the turbo pump using a pressure gauge (Pfeiffer Vacuum PKR 251). When the pressure has been reduced to 10⁻⁵ mbar, the temperature is increased in increments of 10 to 30 K till the compound starts to be deposited in the harvesting zone of the sublimation apparatus. The temperature is further increased in increments of 10 to 30 K till a sublimation rate is achieved where the compound in the source is visibly depleted over 30 min to 1 hour and a substantial amount of compound has accumulated in the harvesting zone.

The sublimation temperature, also named T_{subl}, is the temperature inside the sublimation apparatus at which the compound is deposited in the harvesting zone at a visible rate and is measured in degree Celsius.

In the context of the present invention, the term "sublimation" may refer to a transfer from solid state to gas phase or from liquid state to gas phase.

### Decomposition temperature

The decomposition temperature, also named T_{dec}, is determined in degree Celsius.

The decomposition temperature is measured by loading a sample of 9 to 11 mg into a Mettler Toledo 100 µL aluminum pan without lid under nitrogen in a Mettler Toledo TGA-DSC machine. The following heating program was used: 25°C isothermal for 3 min; 25°C to 6oo°C with 10 K/min.

The decomposition temperature was determined based on the onset of the decomposition in TGA.

### Calculated HOMO and LUMO

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

### General procedure for fabrication of OLEDs

For Examples 1 to 4 and comparative examples 1 and 2 according to table 2, a glass substrate with an anode layer comprising a first anode sub-layer of 120 nm Ag, a second anode sub-layer of 8 nm ITO and a third anode sub-layer of 10 nm ITO was cut to a size of 50 mm × 50 mm × 0.7 mm, ultrasonically washed with water for 60 minutes and then with isopropanol for 20 minutes. The liquid film was removed in a nitrogen stream, followed by plasma treatment, see Table 2, to prepare the anode layer. The plasma treatment was performed in an atmosphere comprising 97.6 vol.-% nitrogen and 2.4 vol.-% oxygen.

Then, F2 (as disclosed herein with respect to exemplary matrix compounds) as a substantially covalent matrix compound and a compound of formula (1) were co-deposited in vacuum on the anode layer, to form a hole injection layer (HIL) having a thickness of 10 nm. The composition of the HIL can be seen in Table 2.

Then, the substantially covalent matrix compound was vacuum deposited on the HIL, to form a HTL having a thickness of 123 nm. The formula of the substantially covalent matrix compound in the HTL was identical to the substantially covalent matrix compound used in the HIL.

Then N-([1,1'-biphenyl]-4-yl)-9,9-diphenyl-N-(4-(triphenylsilyl)phenyl)-9H-fluoren-2-amine (CAS 1613079-70-1) was vacuum deposited on the HTL, to form an electron blocking layer (EBL) having a thickness of 5 nm.

Then 97 vol.-% Hog (Sun Fine Chemicals, Korea) as EML host and 3 vol.-% BD200 (Sun Fine Chemicals, Korea) as fluorescent blue emitter dopant were deposited on the EBL, to form a blue-emitting first emission layer (EML) with a thickness of 20 nm.

Then a hole blocking layer was formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer EML.

Then the electron transporting layer having a thickness of 31 nm was formed on the hole blocking layer by depositing 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% of LiQ.

Then Ag:Mg (90:10 vol.-%) was evaporated at a rate of 0.01 to 1 Å/s at 10⁻⁷ mbar to form a cathode layer with a thickness of 13 nm on the electron transporting layer.

Then, compound of formula F3 was deposited on the cathode layer to form a capping layer with a thickness of 75 nm.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing an operating voltage U in V and measuring the current in mA flowing through the device under test. The voltage applied to the device is varied in steps of 0.1V in the range between oV and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values.

Lifetime LT of the device is measured at ambient conditions (20°C) and 30 mA/cm², using a Keithley 2400 sourcemeter, and recorded in hours. The brightness of the device is measured using a calibrated photo diode. The lifetime LT is defined as the time till the brightness of the device is reduced to 97 % of its initial value.

To determine the voltage stability over time U(50h)-(1h), a current density of at 30 mA/cm² was applied to the device. The operating voltage was measured after 1 hour and after 50 hours, followed by calculation of the voltage stability for the time period of 1 hour to 50 hours.

### Technical Effects of the invention

### Thermal properties

In order to investigate the usefulness of the inventive compound preferred materials were tested in view of their thermal properties.

As materials for organic electronics are typically purified by sublimation, a high decomposition temperature T_{dec} and/or a large offset between decomposition and sublimation temperature T_{dec}-T_{subl} are highly desirable. Thereby, a high sublimation rate may be achievable.

**Table 1: Thermal properties of inventive compounds of formula (1) and comparative examples**

| | **Name/Structure** | **T_{dec} [°C]** | **T_{dec}-T_{subl} [°C]** |
|---|---|---|---|
| Comparative example 1 | Cu [TFSI]₂ | 180 | 5-10°C |
| Comparative example 2 | Ag [TFSI] | 320 | 5-10°C |
| B-1 | 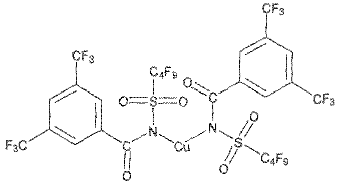 | >286°C | >84°C |
| B-2 | 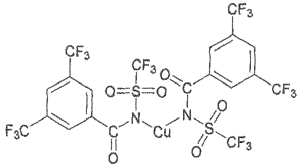 | >255°C | >63°C |
| B-3 | 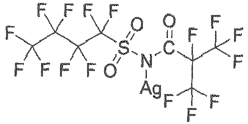 | >336°C | >70°C |
| B-4 | 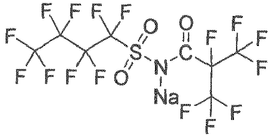 | >348°C | >29°C |
| B-5 | 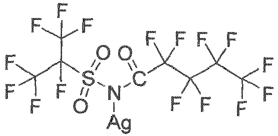 | >313°C | >26°C |
| B-6 | 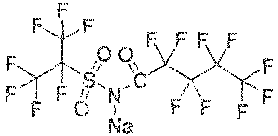 | >320°C | >22°C |
| B-8 | 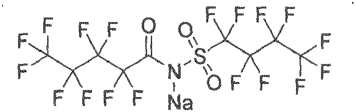 | Not. Obs. | - |

In Table 1 are shown the temperature at which thermal decomposition is observed (T_{dec}), difference between decomposition and sublimation temperature T_{dec-}T_{subl} are shown. It is apparent that the inventive compounds B-1 to B-6 may show a higher decomposition temperature and/or a much larger gap between decay and sublimation temperature.

### Device performance

**Table 2: Performance of organic electronic devices comprising compound of formula (1)**

| | **Compound of formula (I)** | **Percentage of compound of formula (I) (vol.-%)** | **Matrix compound (cf. above)** | **Voltage U at 10 mA/cm² [V]** | **C_{Eff}/CIE-y [cd/A]** |
|---|---|---|---|---|---|
| Comparative example 1 | Cu[N(SO₂CF₃)₂]₂ | 1 | F2 | <4 | 133 |
| Comparative example 2 | Li[N(SO₂CF₃)₂] | 1 | F2 | <4 | 139 |
| Example 1 | B-1 | 1 | F2 | <4 | 155,1 |
| Example 2 | B-3 | 1 | F2 | <4 | 149,5 |
| Example 3 | B-4 | 3 | F2 | <4 | 151,3 |
| Example 4 | B-8 | 2 | F2 | <4 | 144,2 |

As can be seen from Table 2, the current efficiency (C_{Eff}) may be higher than for the comparative example. A high efficiency may be beneficial for reduced power consumption and improved battery life, in particular in mobile devices.

## Claims

1. An organic electronic device comprising an anode (120), a cathode (190), at least one photoactive layer (150), and at least one semiconductor layer (130); wherein the at least one semiconductor layer is arranged between the anode and at least one photoactive layer, wherein the at least one semiconductor layer comprises a compound comprising a metal M and at least one ligand L represented by formula (1) 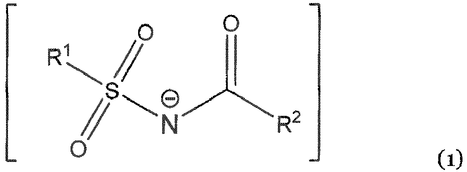 wherein
- R¹ is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R² is independently selected from a substituted or unsubstituted C₁ to C₂₀ alkyl, a substituted or unsubstituted C₃ to C₂₀ carbocyclyl, a substituted or unsubstituted C₂ to C₂₀ heterocyclyl, a substituted or unsubstituted C₆ to C₂₀ aryl, or a substituted or unsubstituted C₂ to C₂₀ heteroaryl;
- R¹ and R² can be connected via a direct bond; and
- R¹ and/or R² taken together with the neighboring sulfur, nitrogen or carbon atom can form a ring, and the ring may be a substituted or unsubstituted ring or a substituted or unsubstituted polycyclic ring or substituted or unsubstituted condensed rings.

2. The organic electronic device according to claim 1, wherein the compound is represented by Formula (2)
Mⁿ⁺Lₙ (2)
wherein n is an integer from 1 to 4;
and each L is selected independently.

3. The organic electronic device according to claim 1 or 2, wherein the metal M is selected from an alkali metal, an alkaline earth metal, Cu, Ag, Fe, Co, Ti, Zr, Hf, Mo, or W.

4. The organic electronic device according to any of the preceding claims, wherein R¹ is independently selected from a substituted or unsubstituted C₁ to C₂₀ alkyl, a substituted or unsubstituted C₆ to C₂₀ aryl, or a substituted or unsubstituted C₂ to C₂₀ heteroaryl.

5. The organic electronic device according to any of the preceding claims, wherein R² is independently selected from a substituted C₁ to C₂₀ alkyl.

6. The organic electronic device according to any of the preceding claims, wherein at least one of R¹ and R² is substituted and at least one substituent on R¹ and/or R² is an electron-withdrawing group.

7. The organic electronic device according to claim 6, wherein the electron-withdrawing group is independently selected from Cl, F, CN, or a partially fluorinated or perfluorinated C₁ to C₁₀ alkyl.

8. The organic electronic device according to any of the preceding claims, wherein the compound is selected from B-1 to B-8
| | |
|---|---|
| 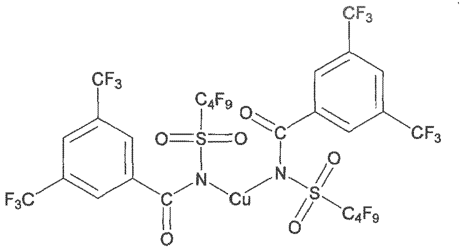 | 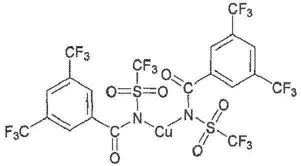 |
| B-1 | B-2 |
| 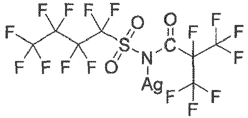 | 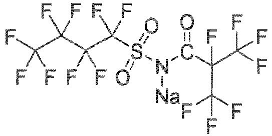 |
| B-3 | B-4 |
| 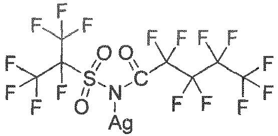 | 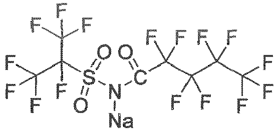 |
| B-5 | B-6 |
| 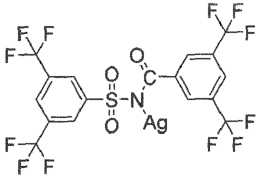 | 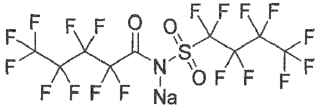 |
| B-7 | B-8 |

9. The organic electronic device according to any of the preceding claims, wherein the semiconductor layer is a hole injection layer or a hole transport layer.

10. A display device comprising the organic electronic device according to any of the preceding claims.

11. A compound represented by formula (3) 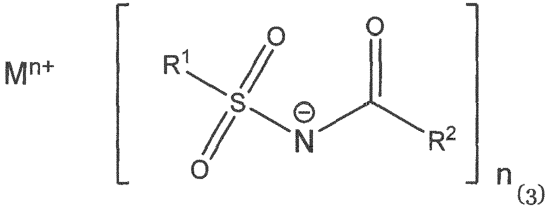 wherein
- M is main group metal, or a transition metal;
- n is an integer from 1 to 4;
- R¹ is independently selected from an unsubstituted C₁ to C₈ alkyl, a partially or perfluorinated C₂ to C₈ alkyl, a substituted or unsubstituted C₆ to C₂₀ aryl, a substituted or unsubstituted C₂ to C₂₀ heteroaryl, a substituted or unsubstituted C₃ to C₂₀ carbocyclyl, or a substituted or unsubstituted C₂ to C₂₀ heterocyclyl;
- R² is independently selected from a substituted or unsubstituted C₁ to C₈ alkyl, substituted or unsubstituted C₆ to C₂₀ aryl, a substituted or unsubstituted C₂ to C₂₀ heteroaryl, a substituted or unsubstituted C₃ to C₂₀ carbocyclyl, or substituted or unsubstituted C₂ to C₂₀ heterocyclyl;
- if at least one of R¹ and R² is aryl or heteroaryl and at least one of the aryl and the heteroaryl is substituted, then the one or more substituent(s) on aryl and heteroaryl is/are independently selected from F, CN, or a partially or perfluorinated C₁ to C₈ alkyl; and
- the following compounds are excluded: 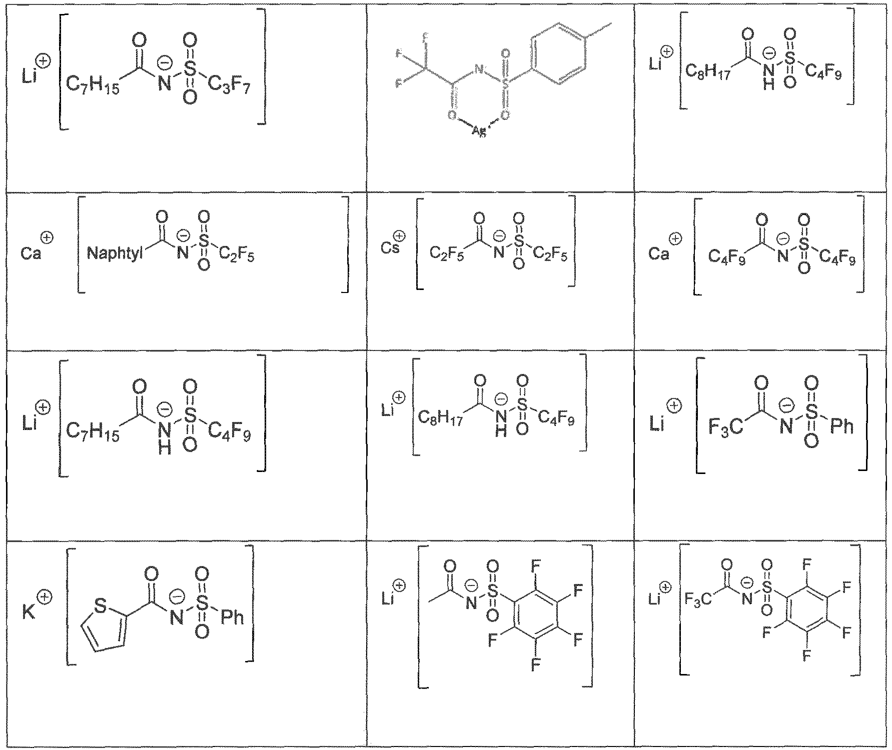 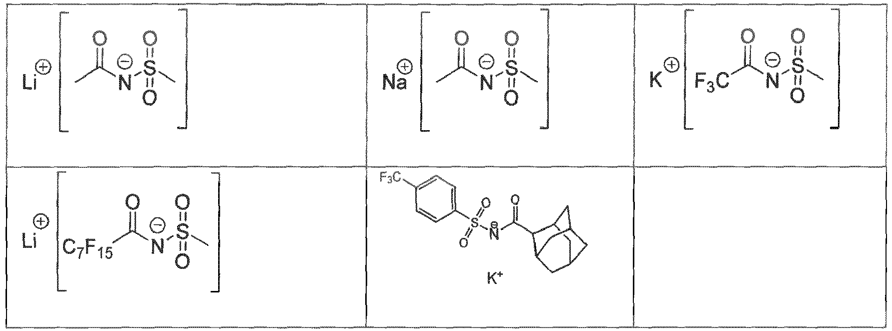 and compounds are excluded which are represented by the formula (4) 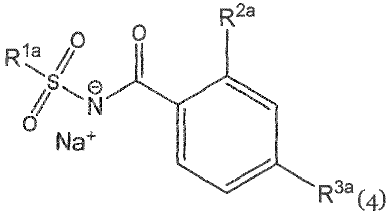 wherein
R^{1a} is pyridyl which is optionally substituted one to three times by a)-O-phenyl, wherein the phenyl is one or two times substituted by halogen, cyano, alkyl, alkoxy, nitro, amino, alkylamino or dialkylamino; b) -NRR', wherein R and R' independently represent hydrogen or alkyl; or alternatively R and R' form together with the nitrogen atom to which they are attached a saturated 5 to 7 membered heterocycle, which is optionally substituted one to three times by alkyl or alkoxy; c) halogen; or d) alkyl; R^{2a} is fluorine, chlorine, bromine, methyl, methoxy or trifluoromethyl; R^{3a} is fluorine, chlorine, bromine, methyl or trifluoromethyl.

12. The compound according to claim 11, wherein
- M has an atomic weight of more than 7; R¹ is independently selected from perfluorinated C₂ to C₈ alkyl; and R² is independently selected from unsubstituted C₁ to C₈ alkyl;
or
- M is a main group metal except Li, Na, Ca and Cs, or a transition metal; R¹ is independently selected from perfluorinated C₂ to C₈ alkyl; and R² is independently selected from a partially fluorinated and perfluorinated C₁ to C₈ alkyl;
or
- R¹ is independently selected from partially fluorinated C₂ to C₈ alkyl;
or
- M is a main group metal except Na and Ca, or a transition metal; R¹ is independently selected from partially fluorinated or perfluorinated C₂ to C₈ alkyl; and R² is independently selected from substituted or unsubstituted C₆ to C₂₀ aryl, or substituted or unsubstituted C₂ to C₂₀ heteroaryl;
or
- M is a main group metal, or a transition metal; R¹ is independently selected from partially fluorinated or perfluorinated C₂ to C₈ alkyl; and R² is independently selected from substituted C₆ to C₂₀ aryl, or substituted C₂ to C₂₀ heteroaryl, wherein the one or more substituents on the aryl and/or heteroaryl are independently F or CF₃;
or
- M has an atomic weight of more than 7; R¹ is independently selected from unsubstituted C₁ to C₈ alkyl; and R² is independently selected from a substituted or unsubstituted C₂ to C₈ alkyl, substituted or unsubstituted C₆ to C₂₀ aryl, or substituted or unsubstituted C₂ to C₂₀ heteroaryl;
or
- M has an atomic weight of more than 7; R¹ is independently selected from substituted or unsubstituted C₆ to C₂₀ aryl, or substituted or unsubstituted C₂ to C₂₀ heteroaryl; and R² is independently selected from a substituted or unsubstituted C₁ to C₈ alkyl, substituted or unsubstituted C₆ to C₂₀ aryl, or substituted or unsubstituted C₂ to C₂₀ heteroaryl; with the provisio that
(a) if R¹ is unsubstituted phenyl, unsubstituted tolyl, or perfluorinated phenyl then M is not Ag,
(b) if R¹ is pyridyl, and R² is 2,4-substituted phenyl then M is not Na, and
(c) if R¹ is unsubstituted phenyl and R² is thiophenyl then M is not K.

13. The compound according to claim 11 or 12, wherein
- M is selected from Cu, Na or Ag;
- n is an integer from 1 or 2; and
- R¹ and R² are independently selected from perfluorinated propyl, perfluorinated butyl, or 3,5-bis(trifluormethyl)phenyl.

14. The compound according to any of the claims 11 to 13, wherein the compound is selected from B-1 and B-3 to B-8
| | |
|---|---|
| 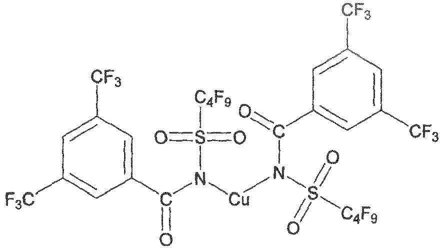 | |
| B-1 | |
| 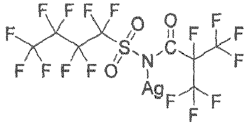 | 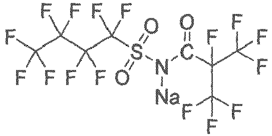 |
| B-3 | B-4 |
| 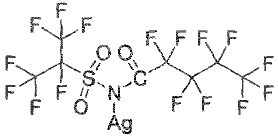 | 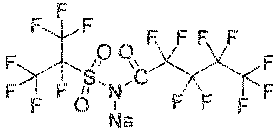 |
| B-5 | B-6 |
| 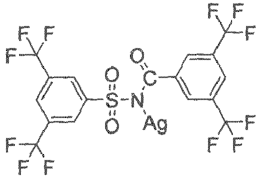 | 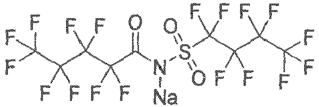 |
| B-7 | B-8 |

15. A compound represented by formula (5) 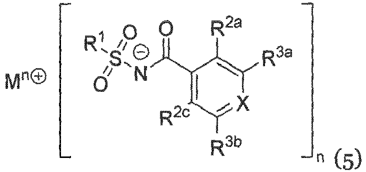 wherein
- M is a metal;
- n is an integer from 1 to 4;
- X is N or C-R^{2b};
- R¹ is selected from a partially or perfluorinated C₁ to C₈ alkyl, a substituted phenyl or unsubstituted or substituted C₃ to C₅ heteroaryl, wherein the substituents are selected from fluorine, chlorine, bromine, methyl, methoxy or trifluoromethyl, or CN;
- R^{2a}, R^{2b}, and R^{2c} are independently selected from fluorine, chlorine, bromine, methyl, methoxy or trifluoromethyl, or CN; and
- R^{3a} and R^{3b} are independently selected from a partially or perfluorinated C₁ to C₈ alkyl, or CN.

## Patentansprüche

1. Organische elektronische Vorrichtung, umfassend eine Anode (120), eine Kathode (190), mindestens eine photoaktive Schicht (150) und mindestens eine Halbleiterschicht (130); wobei die mindestens eine Halbleiterschicht zwischen der Anode und mindestens einer photoaktiven Schicht angeordnet ist, wobei die mindestens eine Halbleiterschicht eine Verbindung umfasst, die ein Metall M und mindestens einen Liganden L umfasst, dargestellt durch Formel (1) 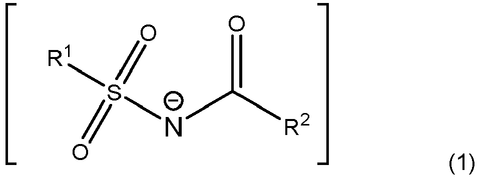 wobei
- R¹ unabhängig ausgewählt ist aus einem substituierten oder unsubstituierten C₁- bis C₂₀-Alkyl, einem substituierten oder unsubstituierten C₃- bis C₂₀-Carbocyclyl, einem substituierten oder unsubstituierten C₂- bis C₂₀-Heterocyclyl, einem substituierten oder unsubstituierten C₆- bis C₂₀-Aryl oder einem substituierten oder unsubstituierten C₂- bis C₂₀-Heteroaryl;
- R² unabhängig ausgewählt ist aus einem substituierten oder unsubstituierten C₁- bis C₂₀-Alkyl, einem substituierten oder unsubstituierten C₃- bis C₂₀-Carbocyclyl, einem substituierten oder unsubstituierten C₂- bis C₂₀-Heterocyclyl, einem substituierten oder unsubstituierten C₆- bis C₂₀-Aryl oder einem substituierten oder unsubstituierten C₂- bis C₂₀-Heteroaryl;
- R¹ und R² über eine direkte Bindung verbunden sein können; und
- R¹ und/oder R² zusammen mit dem benachbarten Schwefel-, Stickstoff- oder Kohlenstoffatom einen Ring bilden können und der Ring ein substituierter oder unsubstituierter Ring oder ein substituierter oder unsubstituierter polycyclischer Ring oder substituierte oder unsubstituierte kondensierte Ringe sein kann.

2. Organische elektronische Vorrichtung nach Anspruch 1, wobei die Verbindung durch Formel (2) dargestellt ist
Mⁿ⁺Lₙ (2)
wobei n eine ganze Zahl von 1 bis 4 ist;
und jedes L unabhängig ausgewählt ist.

3. Organische elektronische Vorrichtung nach Anspruch 1 oder 2, wobei das Metall M aus einem Alkalimetall, einem Erdalkalimetall, Cu, Ag, Fe, Co, Ti, Zr, Hf, Mo oder W ausgewählt ist.

4. Organische elektronische Vorrichtung nach einem der vorstehenden Ansprüche, wobei R¹ unabhängig ausgewählt ist aus einem substituierten oder unsubstituierten C₁- bis C₂₀-Alkyl, einem substituierten oder unsubstituierten C₆- bis C₂₀-Aryl oder einem substituierten oder unsubstituierten C₂- bis C₂₀-Heteroaryl.

5. Organische elektronische Vorrichtung nach einem der vorstehenden Ansprüche, wobei R² unabhängig ausgewählt ist aus einem substituierten C₁- bis C₂₀-Alkyl.

6. Organische elektronische Vorrichtung nach einem der vorstehenden Ansprüche, wobei mindestens eines von R¹ und R² substituiert ist und mindestens ein Substituent an R¹ und/oder R² eine elektronenziehende Gruppe ist.

7. Organische elektronische Vorrichtung nach Anspruch 6, wobei die elektronenziehende Gruppe unabhängig ausgewählt ist aus CI, F, CN oder einem teilweise fluorierten oder perfluorierten C₁- bis C₁₀-Alkyl.

8. Organische elektronische Vorrichtung nach einem der vorstehenden Ansprüche, wobei die Verbindung ausgewählt ist aus B-1 bis B-8
| | |
|---|---|
| 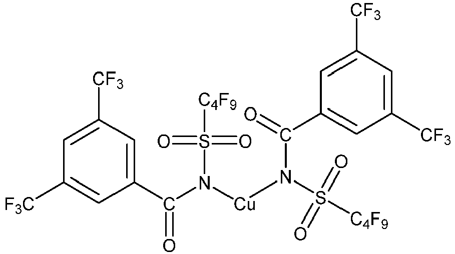 | 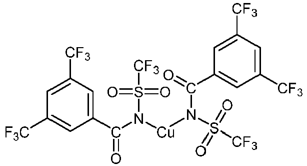 |
| B-1 | B-2 |
| 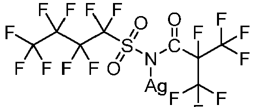 | 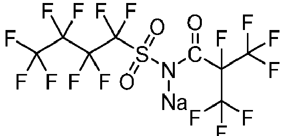 |
| B-3 | B-4 |
| 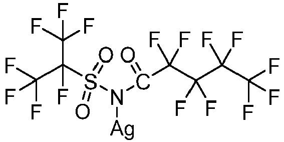 | 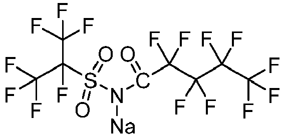 |
| B-5 | B-6 |
| 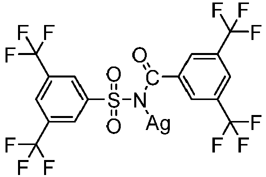 | 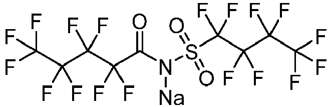 |
| B-7 | B-8 |

9. Organische elektronische Vorrichtung nach einem der vorstehenden Ansprüche, wobei die Halbleiterschicht eine Lochinjektionsschicht oder eine Lochtransportschicht ist.

10. Anzeigevorrichtung, umfassend die organische elektronische Vorrichtung nach einem der vorstehenden Ansprüche.

11. Verbindung, dargestellt durch Formel (3) 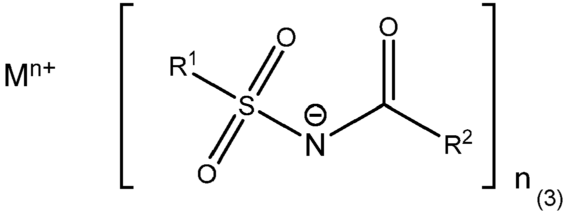 wobei
- M ein Hauptgruppenmetall oder ein Übergangsmetall ist;
- n eine ganze Zahl von 1 bis 4 ist;
- R¹ unabhängig ausgewählt ist aus einem unsubstituierten C₁- bis C₈-Alkyl, einem teilweise oder perfluorierten C₂- bis C₈-Alkyl, einem substituierten oder unsubstituierten C₆- bis C₂₀-Aryl, einem substituierten oder unsubstituierten C₂- bis C₂₀-Heteroaryl, einem substituierten oder unsubstituierten C₃- bis C₂₀-Carbocyclyl oder einem substituierten oder unsubstituierten C₂- bis C₂₀-Heterocyclyl;
- R² unabhängig ausgewählt ist aus einem substituierten oder unsubstituierten C₁- bis C₈-Alkyl, einem substituierten oder unsubstituierten C₆- bis C₂₀-Aryl, einem substituierten oder unsubstituierten C₂- bis C₂₀-Heteroaryl, einem substituierten oder unsubstituierten C₃- bis C₂₀-Carbocyclyl oder einem substituierten oder unsubstituierten C₂- bis C₂₀-Heterocyclyl;
- wenn mindestens eines von R¹ und R² Aryl oder Heteroaryl ist und mindestens eines von dem Aryl und dem Heteroaryl substituiert ist, dann ist/sind der eine oder die mehreren Substituenten an Aryl und Heteroaryl unabhängig ausgewählt aus F, CN oder einem teilweise oder perfluorierten C₁- bis C₈-Alkyl; und
- die folgenden Verbindungen ausgeschlossen sind: 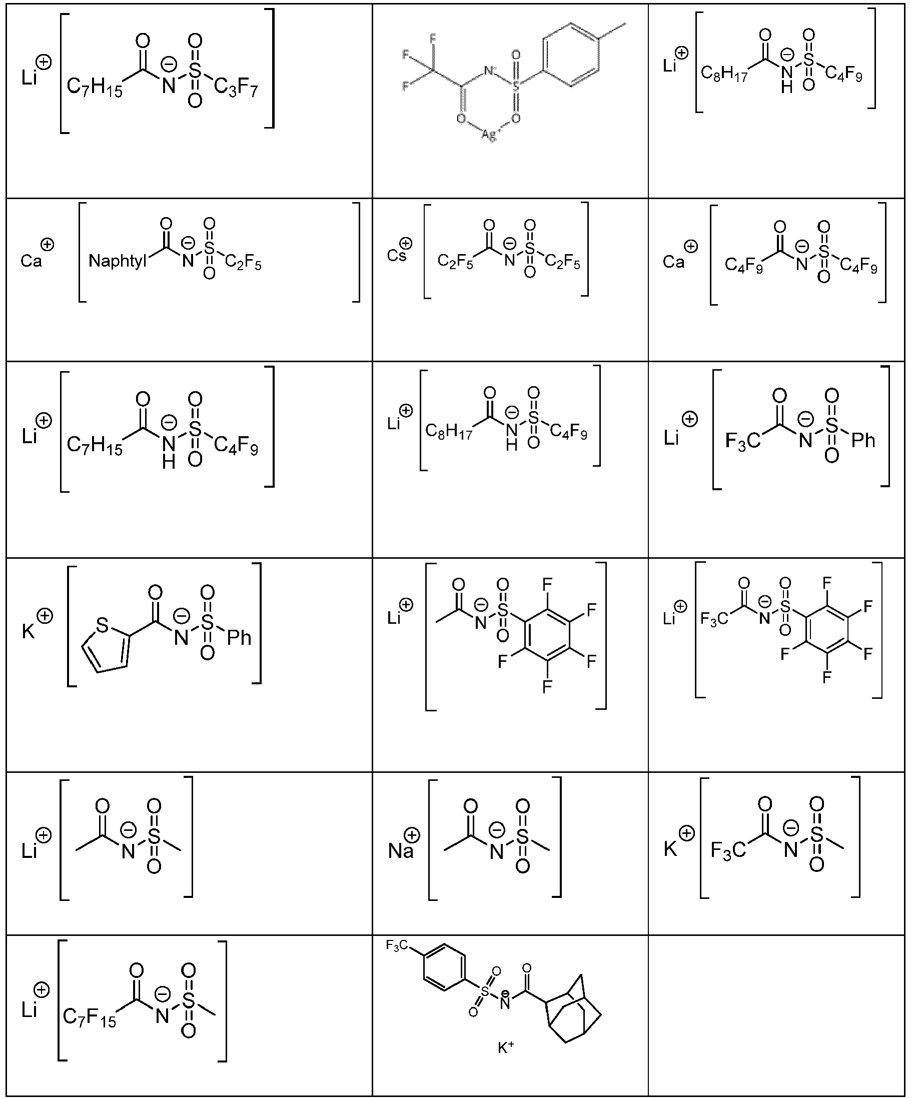 und Verbindungen ausgeschlossen sind, die durch Formel (4) dargestellt sind 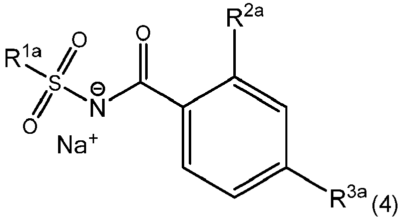 wobei
R^{1a} Pyridyl ist, das gegebenenfalls ein- bis dreimal mit a) -O-Phenyl substituiert ist, wobei das Phenyl ein- oder zweimal mit Halogen, Cyano, Alkyl, Alkoxy, Nitro, Amino, Alkylamino oder Dialkylamino substituiert ist; b) -NRR', wobei R und R' unabhängig Wasserstoff oder Alkyl darstellen; oder alternativ R und R' zusammen mit dem Stickstoffatom, an das sie gebunden sind, einen gesättigten 5- bis 7-gliedrigen Heterocyclus bilden, der gegebenenfalls ein- bis dreimal mit Alkyl oder Alkoxy substituiert ist; c) Halogen; oder d) Alkyl; R^{2a} Fluor, Chlor, Brom, Methyl, Methoxy oder Trifluormethyl ist; R^{3a} Fluor, Chlor, Brom, Methyl oder Trifluormethyl ist.

12. Verbindung nach Anspruch 11, wobei
- M ein Atomgewicht von mehr als 7 aufweist; R¹ unabhängig ausgewählt ist aus perfluoriertem C₂- bis C₈-Alkyl; und R² unabhängig ausgewählt ist aus unsubstituiertem C₁- bis C₈-Alkyl;
oder
- M ein Hauptgruppenmetall außer Li, Na, Ca und Cs oder ein Übergangsmetall ist; R¹ unabhängig ausgewählt ist aus perfluoriertem C₂- bis C₈-Alkyl; und R² unabhängig ausgewählt ist aus einem teilweise fluorierten und perfluorierten C₁- bis C₈-Alkyl;
oder
- R¹ unabhängig ausgewählt ist aus teilweise fluoriertem C₂- bis C₈-Alkyl;
oder
- M ein Hauptgruppenmetall außer Na und Ca oder ein Übergangsmetall ist; R¹ unabhängig ausgewählt ist aus teilweise fluoriertem oder perfluoriertem C₂- bis C₈-Alkyl; und R² unabhängig ausgewählt ist aus substituiertem oder unsubstituiertem C₆- bis C₂₀-Aryl oder substituiertem oder unsubstituiertem C₂- bis C₂₀-Heteroaryl;
oder
- M ein Hauptgruppenmetall oder ein Übergangsmetall ist; R¹ unabhängig ausgewählt ist aus teilweise fluoriertem oder perfluoriertem C₂- bis C₈-Alkyl; und R² unabhängig ausgewählt ist aus substituiertem C₆- bis C₂₀-Aryl oder substituiertem C₂- bis C₂₀-Heteroaryl, wobei der eine oder die mehreren Substituenten an dem Aryl und/oder Heteroaryl unabhängig F oder CF₃ sind;
oder
- M ein Atomgewicht von mehr als 7 aufweist; R¹ unabhängig ausgewählt ist aus unsubstituiertem C₁- bis C₈-Alkyl; und R² unabhängig ausgewählt ist aus einem substituierten oder unsubstituierten C₂- bis C₈-Alkyl, substituierten oder unsubstituierten C₆- bis C₂₀-Aryl oder substituierten oder unsubstituierten C₂- bis C₂₀-Heteroaryl;
oder
- M ein Atomgewicht von mehr als 7 aufweist; R¹ unabhängig ausgewählt ist aus substituiertem oder unsubstituiertem C₆- bis C₂₀-Aryl oder substituiertem oder unsubstituiertem C₂- bis C₂₀-Heteroaryl; und R² unabhängig ausgewählt ist aus einem substituierten oder unsubstituierten C1- bis C₈-Alkyl, substituierten oder unsubstituierten C₆- bis C₂₀-Aryl oder substituierten oder unsubstituierten C₂- bis C₂₀-Heteroaryl; mit der Maßgabe, dass
(a) wenn R¹ unsubstituiertes Phenyl, unsubstituiertes Tolyl oder perfluoriertes Phenyl ist, dann ist M nicht Ag,
(b) wenn R¹ Pyridyl ist und R² 2,4-substituiertes Phenyl ist, dann ist M nicht Na, und
(c) wenn R¹ unsubstituiertes Phenyl ist und R² Thiophenyl ist, dann ist M nicht K.

13. Verbindung nach Anspruch 11 oder 12, wobei
- M aus Cu, Na oder Ag ausgewählt ist;
- n eine ganze Zahl von 1 oder 2 ist; und
- R¹ und R² unabhängig ausgewählt sind aus perfluoriertem Propyl, perfluoriertem Butyl oder 3,5-Bis(trifluormethyl)phenyl.

14. Verbindung nach einem der Ansprüche 11 bis 13, wobei die Verbindung ausgewählt ist aus B-1 und B-3 bis B-8
| | |
|---|---|
| 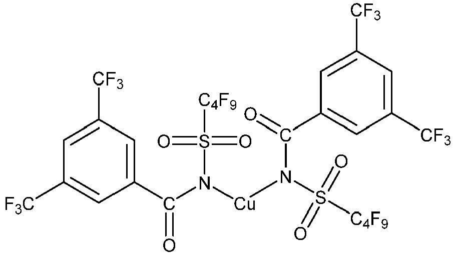 | |
| B-1 | |
| 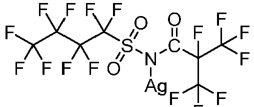 | 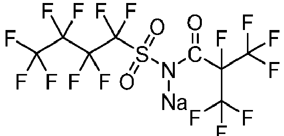 |
| B-3 | B-4 |
| 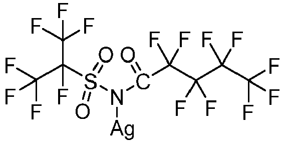 | 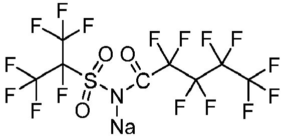 |
| B-5 | B-6 |
| 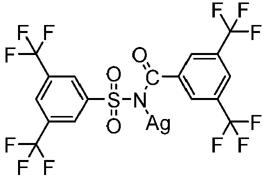 | 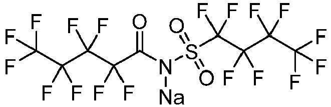 |
| B-7 | B-8 |

15. Verbindung, dargestellt durch Formel (5) 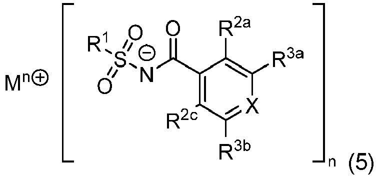 wobei
- M ein Metall ist;
- n eine ganze Zahl von 1 bis 4 ist;
- X N oder C-R^{2b} ist;
- R¹ ausgewählt ist aus einem teilweise oder perfluorierten C₁- bis C₈-Alkyl, einem substituierten Phenyl oder unsubstituierten oder substituierten C₃- bis C₅-Heteroaryl, wobei die Substituenten ausgewählt sind aus Fluor, Chlor, Brom, Methyl, Methoxy oder Trifluormethyl oder CN;
- R^{2a}, R^{2b} und R^{2c} unabhängig ausgewählt sind aus Fluor, Chlor, Brom, Methyl, Methoxy oder Trifluormethyl oder CN; und
- R^{3a} und R^{3b} unabhängig ausgewählt sind aus einem teilweise oder perfluorierten C₁-bis C₈-Alkyl oder CN.

## Revendications

1. Dispositif électronique organique comprenant une anode (120), une cathode (190), au moins une couche photoactive (150) et au moins une couche semi-conductrice (130) ;
dans lequel au moins une couche semi-conductrice est disposée entre l'anode et au moins une couche photoactive, dans lequel l'au moins une couche semi-conductrice comprend un composé comprenant un métal M et au moins un ligand L représenté par la formule (1) 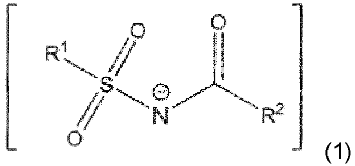
dans laquelle
- R¹ est indépendamment choisi parmi un alkyle en C₁ à C₂₀ substitué ou non substitué, un carbocyclyle en C₃ à C₂₀ substitué ou non substitué, un hétérocyclyle en C₂ à C₂₀ substitué ou non substitué, un aryle en C₆ à C₂₀ substitué ou non substitué, ou un hétéroaryle en C₂ à C₂₀ substitué ou non substitué ;
- R² est indépendamment choisi parmi un alkyle en C₁ à C₂₀ substitué ou non substitué, un carbocyclyle en C₃ à C₂₀ substitué ou non substitué, un hétérocyclyle en C₂ à C₂₀ substitué ou non substitué, un aryle en C₆ à C₂₀ substitué ou non substitué, ou un hétéroaryle en C₂ à C₂₀ substitué ou non substitué ;
- R¹ et R² peuvent être reliés par une liaison directe ; et
- R¹ et/ou R² pris ensemble avec l'atome de soufre, d'azote ou de carbone voisin peuvent former un anneau, et l'anneau peut être un anneau substitué ou non substitué ou un anneau polycyclique substitué ou non substitué ou des anneaux condensés substitués ou non substitués.

2. Dispositif électronique organique selon la revendication 1, dans lequel le composé est représenté par la formule (2)
Mⁿ⁺Lₙ (2)
dans laquelle n est un nombre entier compris entre 1 et 4 ;
et chaque L est choisi indépendamment.

3. Dispositif électronique organique selon la revendication 1 ou la revendication 2, dans lequel le métal M est choisi parmi un métal alcalin, un métal alcalino-terreux, Cu, Ag, Fe, Co, Ti, Zr, Hi, Mo ou W.

4. Dispositif électronique organique selon l'une quelconque des revendications précédentes, dans lequel R¹ est indépendamment choisi parmi un alkyle en C₁ à C₂₀ substitué ou non substitué, un aryle en C₆ à C₂₀ substitué ou non substitué, ou un hétéroaryle en C₂ à C₂₀ substitué ou non substitué.

5. Dispositif électronique organique selon l'une quelconque des revendications précédentes, dans lequel R² est indépendamment choisi parmi un alkyle en C₁ à C₂₀ substitué.

6. Dispositif électronique organique selon l'une quelconque des revendications précédentes, dans lequel au moins un des R¹ et R² est substitué et au moins un substituant sur R¹ et/ou R² est un groupe électroattracteur.

7. Dispositif électronique organique selon la revendication 6, dans lequel le groupe électroattracteur est indépendamment choisi parmi Cl, F, CN, ou un alkyle en C₁ à C₁₀ partiellement fluoré ou perfluoré.

8. Dispositif électronique organique selon l'une quelconque des revendications précédentes, dans lequel le composé est choisi parmi les composés B-1 à B-8
| | |
|---|---|
| 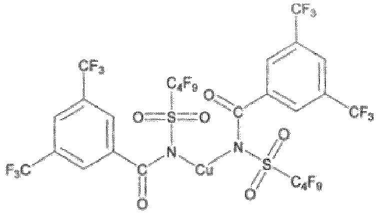 | 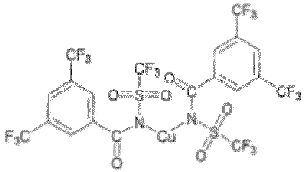 |
| B-1 | B-2 |
| 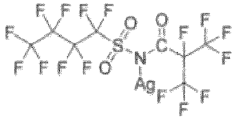 | 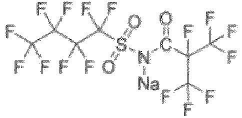 |
| B-3 | B-4 |
| 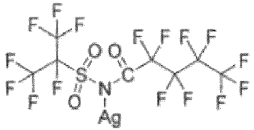 | 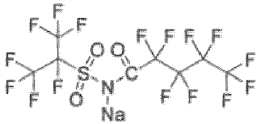 |
| B-5 | B-6 |
| 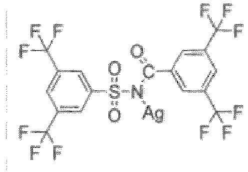 | 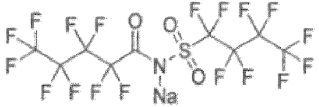 |
| B-7 | B-8 |

9. Dispositif électronique organique selon quelconque des revendications précédentes, dans lequel la couche semi-conductrice est une couche d'injection de trous ou une couche de transport de trous.

10. Dispositif d'affichage comprenant le dispositif électronique organique selon l'une quelconque des revendications précédentes.

11. Composé représenté par la formule (3) 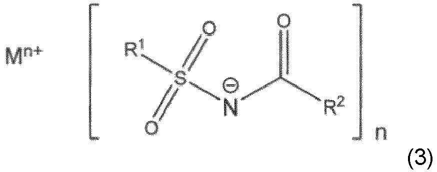 dans laquelle
- M est un métal du groupe principal ou un métal de transition ;
- n est un nombre entier compris entre 1 et 4 ;
- R¹ est indépendamment choisi parmi un alkyle en C₁ à C₈ non substitué, un alkyle en C₂ à C₈ partiellement fluoré ou perfluoré, un aryle en C₆ à C₂₀ substitué ou non substitué, un hétéroaryle en C₂ à C₂₀ substitué ou non substitué, un carbocyclyle en C₃ à C₂₀ substitué ou non substitué, ou un hétérocyclyle en C₂ à C₂₀ substitué ou non substitué ;
- R² est indépendamment choisi parmi un alkyle en C₁ à C₈ substitué ou non substitué, un aryle en C₆ à C₂₀ substitué ou non substitué, un hétéroaryle en C₂ à C₂₀ substitué ou non substitué, un carbocyclyle en C₃ à C₂₀ substitué ou non substitué, ou un hétérocyclyle en C₂ à C₂₀ substitué ou non substitué ;
- si au moins un des groupes R¹ et R² est un aryle ou un hétéroaryle et qu'au moins un des aryles et des hétéroaryles est substitué, le ou les substituants sur l'aryle et l'hétéroaryle sont choisis indépendamment parmi F, CN ou un alkyle en C₁ à C₈ partiellement fluoré ou perfluoré ; et
- les composés suivants sont exclus : 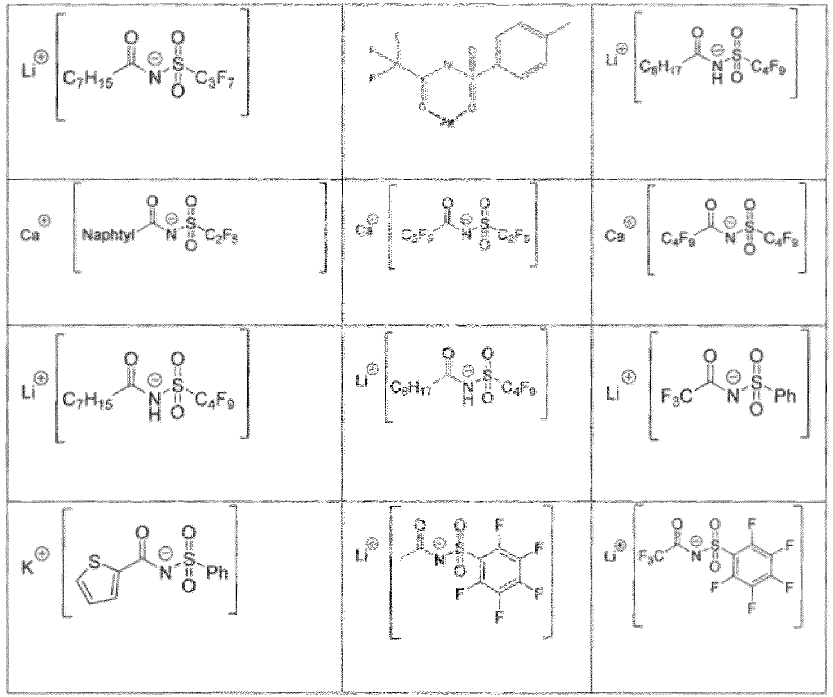 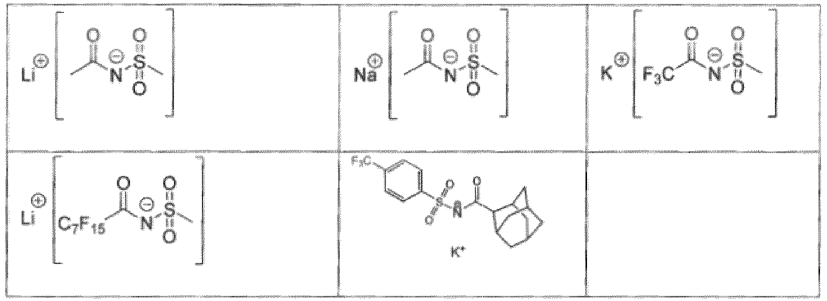 et sont exclus les composés représentés par la formule (4) 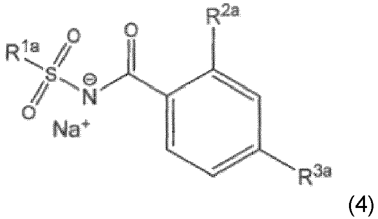 dans laquelle
R^{1a} est un pyridyle qui est éventuellement substitué une à trois fois par a)-O-phényle, dans laquelle le phényle est substitué une ou deux fois par un halogène, un cyano, un alkyle, un alkoxy, un nitro, un amino, un alkylamino ou un dialkylamino ; b) -NRR', dans laquelle R et R' représentent indépendamment un atome d'hydrogène ou un alkyle ; ou alternativement, R et R' forment avec l'atome d'azote auquel ils sont liés un hétérocycle saturé de 5 à 7 membres, qui est éventuellement substitué une à trois fois par un alkyle ou un alcoxy ; c) un halogène ; ou d) un alkyle ; R^{2a} représente le fluor, le chlore, le brome, le méthyle, le méthoxy ou le trifluorométhyle ; R^{3a} représente le fluor, le chlore, le brome, le méthyle ou le trifluorométhyle.

12. Composé selon la revendication 11, dans lequel
- M a un poids atomique supérieur à 7 ; R¹ est indépendamment choisi parmi les alkyles perfluorés en C₂ à C₈ ; et R² est indépendamment choisi parmi les alkyles en C₁ à C₈ non substitués ;
ou
- M est un métal du groupe principal, à l'exception de Li, Na, Ca et Cs, ou un métal de transition ; R¹ est indépendamment choisi parmi les alkyles perfluorés en C₂ à C₈ ; et R² est indépendamment choisi parmi les alkyles en C₁ à C₈ partiellement fluorés et perfluorés ;
ou
- R¹ est indépendamment choisi parmi les alkyles en C₂ à C₈ partiellement fluorés ;
ou
- M est un métal du groupe principal, à l'exception de Na et Ca, ou un métal de transition ; R¹ est indépendamment choisi parmi les alkyles en C₂ à C₈ partiellement fluorés ou perfluorés ; et R² est indépendamment choisi parmi les aryles en C₆ à C₂₀ substitués ou non substitués, ou les hétéroaryles en C₂ à C₂₀ substitués ou non substitués ;
ou
- M est un métal du groupe principal ou un métal de transition ; R¹ est indépendamment choisi parmi les alkyles C₂ à C₈ partiellement fluorés ou perfluorés ; et R² est indépendamment choisi parmi les aryles C₆ à C₂₀ substitués ou les hétéroaryles C₂ à C₂₀ substitués, dans lesquels le ou les substituants sur l'aryle et/ou l'hétéroaryle sont indépendamment F ou CF₃ ;
ou
- M a un poids atomique supérieur à 7 ; R¹ est indépendamment choisi parmi les alkyles en C₁ à C₈ non substitués ; et R² est indépendamment choisi parmi les alkyles en C₂ à C₈ substitués ou non substitués, les aryles en C₆ à C₂₀ substitués ou non substitués, ou les hétéroaryles en C₂ à C₂₀ substitués ou non substitués ;
ou
- M a un poids atomique supérieur à 7 ; R¹ est indépendamment choisi parmi les aryles en C₆ à C₂₀ substitués ou non substitués, ou les hétéroaryles en C₂ à C₂₀ substitués ou non substitués ; et R² est indépendamment choisi parmi les alkyles en C₁ à C₈ substitués ou non substitués, les aryles en C₆ à C₂₀ substitués ou non substitués, ou les hétéroaryles en C₂ à C₂₀ substitués ou non substitués ; sous réserve de ce qui suit
(a)si R¹ est un phényle non substitué, un tolyle non substitué ou un phényle perfluoré, M ne représente pas Ag,
(b)si R¹ est un pyridyle et R² un phényle substitué en position 2,4, M ne représente pas Na, et
(c)si R¹ est un phényle non substitué et R² un thiophényle, M ne représente pas K.

13. Composé selon la revendication 11 ou la revendication 12, dans lequel
- M est choisi parmi Cu, Na ou Ag ;
- n est un nombre entier compris entre 1 et 2 ; et
- R¹ et R² sont indépendamment choisis parmi le propyle perfluoré, le butyle perfluoré ou le 3,5-bis(trifluorméthyl)phényle.

14. Composé selon l'une quelconque des revendications 11 à 13, dans lequel le composé est choisi parmi B-1 et B-3 à B-8
| | |
|---|---|
| 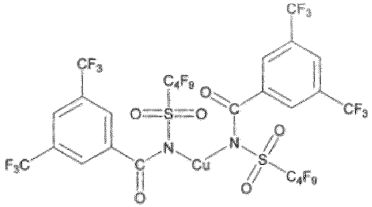 | |
| B-1 | |
| 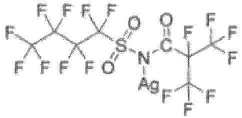 | 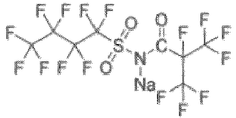 |
| B-3 | B-4 |
| 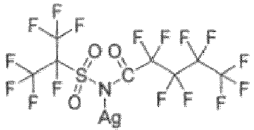 | 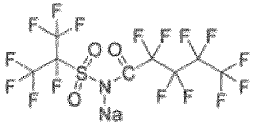 |
| B-5 | B-6 |
| 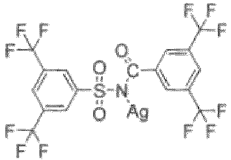 | 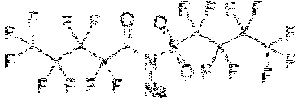 |
| B-7 | B-8 |

15. Composé représenté par la formule (5) dans laquelle 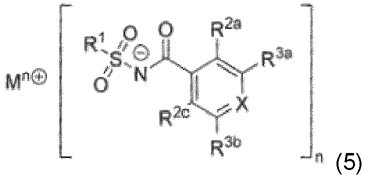
- M représente un métal ;
- n est un nombre entier compris entre 1 et 4 ;
- X représente N ou C-R^{2b} ;
- R¹ est choisi parmi un alkyle en C₁ à C₈ partiellement fluoré ou perfluoré, un phényle substitué ou un hétéroaryle en C₃ à C₅ substitué ou non substitué, les substituants étant choisis parmi le fluor, le chlore, le brome, le méthyle, le méthoxy ou le trifluorométhyle, ou CN ;
- R^{2a}, R^{2b} et R^{2c} sont indépendamment choisis parmi le fluor, le chlore, le brome, le méthyle, le méthoxy ou le trifluorométhyle, ou CN ; et
- R^{3a} et R^{3b} sont indépendamment choisis parmi un alkyle en C₁ à C₈ partiellement fluoré ou perfluoré, ou CN.
